(19) Europäisches Patentamt
European Patent Office
Office européen des brevets

(11) **EP 3 529 900 B1**

(12) **EUROPEAN PATENT SPECIFICATION**

(45) Date of publication and mention
of the grant of the patent:
**20.07.2022 Bulletin 2022/29**

(21) Application number: **17716177.5**

(22) Date of filing: **05.04.2017**

(51) International Patent Classification (IPC):
**H03M 13/11** *(2006.01)*

(52) Cooperative Patent Classification (CPC):
**H03M 13/1111; H03M 13/1154; H03M 13/116; H03M 13/616**

(86) International application number:
**PCT/EP2017/058107**

(87) International publication number:
**WO 2018/184672 (11.10.2018 Gazette 2018/41)**

(54) **CONSTRUCTION OF LDPC CONVOLUTIONAL TURBO CODES**

KONSTRUKTION VON TURBO KODES AUF DER BASIS VON LDPC FALTUNGSKODES

CONSTRUCTION DES CODES TURBO À LA BASE DES CODES DE TYPE LDPC CONVOLUTIFS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**28.08.2019 Bulletin 2019/35**

(73) Proprietor: **Huawei Technologies Co., Ltd.
Longgang District
Shenzhen, Guangdong 518129 (CN)**

(72) Inventors:
• **CANNALIRE, Giacomo**
**80992 Munich (DE)**
• **MANFREDI, Marco**
**80992 Munich (DE)**
• **MAZZUCCO, Christian**
**80992 Munich (DE)**

(74) Representative: **Epping - Hermann - Fischer
Patentanwaltsgesellschaft mbH
Schloßschmidstraße 5
80639 München (DE)**

(56) References cited:
**EP-A1- 2 211 469     US-A1- 2016 173 132**

• **CHO JUNHO ET AL: "Construction of protographs for large-girth structured LDPC convolutional codes", PROC. 2015 IEEE INTERNATIONAL CONFERENCE ON COMMUNICATIONS (ICC), IEEE, 8 June 2015 (2015-06-08), pages 4412-4417, XP033199123, DOI: 10.1109/ICC.2015.7249017 [retrieved on 2015-09-09]**
• **ZHENGANG CHEN ET AL: "Jointly Designed Architecture-Aware LDPC Convolutional Codes and High-Throughput Parallel Encoders/Decoders", IEEE TRANSACTIONS ON CIRCUITS AND SYSTEMS I: REGULAR PAPERS, IEEE, US, vol. 57, no. 4, 1 April 2010 (2010-04-01), pages 836-849, XP011333658, ISSN: 1549-8328, DOI: 10.1109/TCSI.2009.2026684**
• **CHUN-HAO LIAO ET AL: "An IP generator for quasi-cyclic LDPC convolutional code decoders", CIRCUITS AND SYSTEMS, 2008. APCCAS 2008. IEEE ASIA PACIFIC CONFERENCE ON, IEEE, PISCATAWAY, NJ, USA, 30 November 2008 (2008-11-30), pages 1652-1655, XP031405327, DOI: 10.1109/APCCAS.2008.4746354 ISBN: 978-1-4244-2341-5**

EP 3 529 900 B1

**Description**

TECHNICAL FIELD

The present invention is directed to a device and to a method for seed matrix generation. Further, the present invention is directed to an encoding device and to an encoding method for encoding information by use of the generated seed matrix. Additionally, the present invention is directed to a decoding device and to a decoding method for decoding information by use of the generated seed matrix.

BACKGROUND

In the area of communication technology encoding and decoding of information has always been an important and challenging issue. It is desired that devices or systems are capable to exchange information in a secure way. However, encoding of information and subsequent decoding of information may lead to information losses and errors. Further, a good encoding and decoding performance is expected.

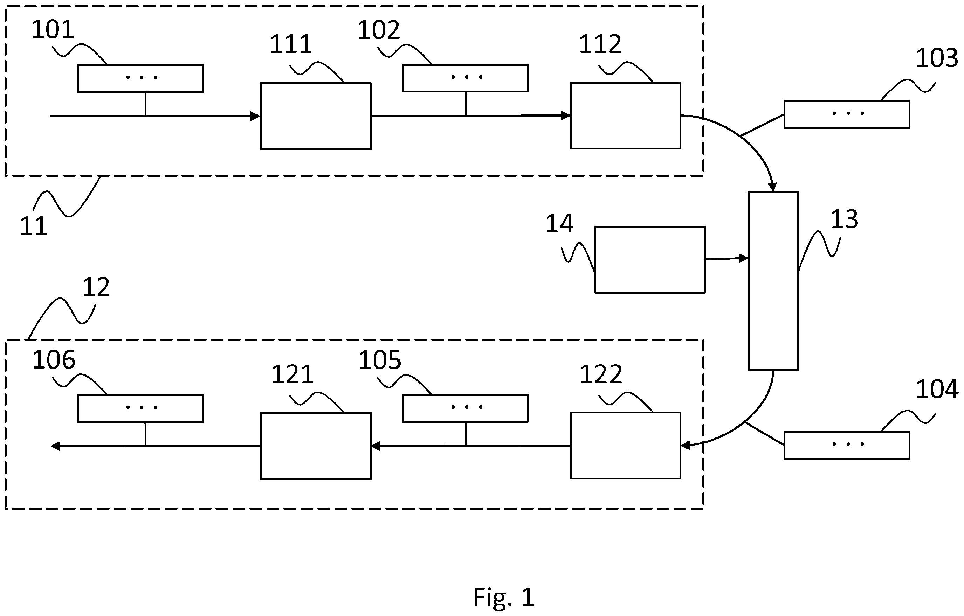

Fig. 1 shows an example of a conventional communication system model where information is encoded and transmitted by an information transmitting device/system and where the encoded information is received and decoded by an information receiving device/system.

According to the exemplary conventional communication system model of Fig. 1, an information transmitting side (e.g., device or system) 11 and an information receiving side (e.g., device or system) 12 are provided. The information transmitting side 11 comprises an encoding device 111 and a modulator 112. The information receiving side 12 comprises a decoding device 121 and a demodulator 122.

The input of the encoding device 111 (e.g., channel encoding device) is an information 101 being a sequence of $ki$ bits to which a redundancy sequence of $r$ bits is added by the encoding device 111 during the encoding process, thereby producing an encoded information 102 being a sequence of $nc$ bits.

The channel code rate R is defined as the ratio between the information bit number $ki$ (i.e., number $ki$ of bits of the information 101) and the encoded bit number $nc$ (i.e., number $nc$ of bits of the encoded information 102). Thus, $R=ki/nc$.

The modulator 112 transforms the encoded information 102 into a modulated signal 103, which is in turn transmitted through a channel 13. Since the channel 13 is usually subject to noisy disturbance 14, the channel output 104, i.e. the encoded information received at the receiving side 12 may differ from the channel input 103, i.e. the encoded information generated and transmitted by the transmitting side 11.

At the receiving side 12, the channel output 104 is processed by the demodulator 122 which performs the MOD inverse operation of the modulator 112 and produces some likelihood ratio.

The channel decoding device 121 uses the redundancy in the received encoded information 105 (output of the demodulator 122) to correct the error in the information of the received encoded information 105 and produces a decoded information 106 which is an estimate of the original information 101.

Known encoding devices and/or decoding devices 111, 121 often use convolutional codes with Low Density Parity Check (LDPC) matrix as proposed, for example, in Alberto Jimenez Felstrom, Kamil Zigangirov: "Time-varying periodic convolutional codes with low density parity-check matrix", IEEE Trans. Information Theory 45 (6): 2181-2191 (1999).

In the convolutional codes, the encoding device 111 contains memory and the "$nc$" encoder outputs 102 (i.e. the $nc$ bits of the encoded information 102, which is a sequence of bits) at any given time unit, depend not only on the "$ki$" inputs 101 (i.e. the $ki$ bits of the information 101 to be encoded, which is a sequence of bits), at that time unit, but also on "$M$" previous input blocks, i.e. previous $M$ information (i.e. information bit sequences 101) that were encoded previously or before respectively.

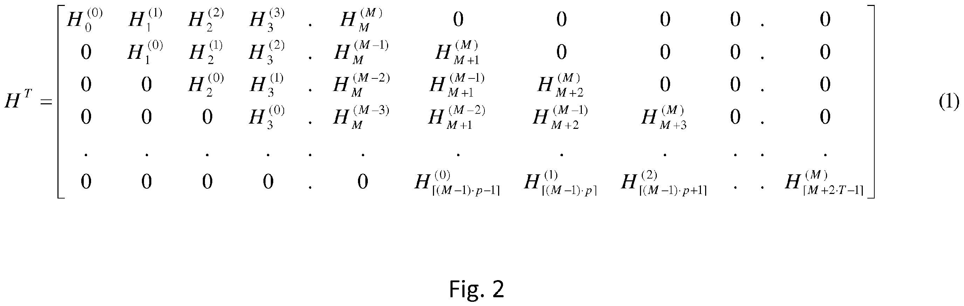

The transposed parity-check matrix, called syndrome matrix, of a periodical binary convolutional code with memory "$M$", code rate "$R=b/c$", code period "$T=M-1$" and code period number "$p$" is, for example, as shown in Fig. 2.

In the equation (1), shown in Fig. 2, each element $H_t^{(m)}$ with "$m=0,1,2, ......M$" and "$t=0,1,... ...$ ", wherein m and t are integers, is a binary sub-matrix with size "$cx(c-b)$".

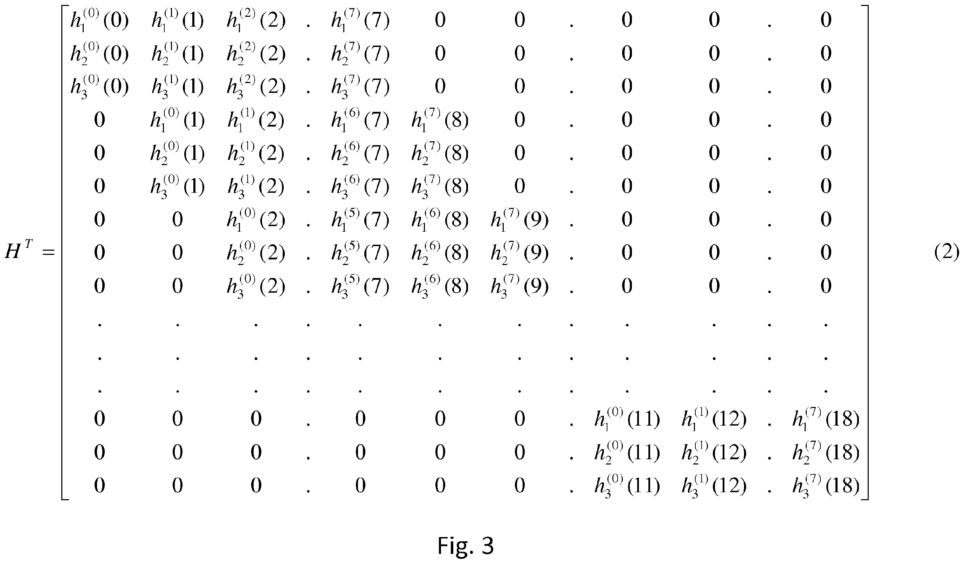

For a code rate "$R= b/c= 2/3$", a code period "$T= M-1 = 6 (M= 7)$" and "$p= 2$" code periods each element of the transposed parity-check matrix $H_t^{(m)}$ is a parity matrix of size $cx(c-b) = 3x1$ then the syndrome matrix $H^T$ of equation (1) of Fig. 2 becomes as shown in equation (2) of Fig. 3.

The low density parity-check matrix is characterized from the following parameters $(M,Ju(Jv),K)$ where $M$ determines the code period $(T=M-1)$, $Ju(Jv)$ are the elements to "$1$" for row and "$K$" are the elements to "$1$" for column.

The parameter *Ju* is the row weight for the information sequence while Jv is the row weight for the parity sequence. The parameter "K" is the column weight starting from the column *[M (c-b) +1]-th.*

Let the information sequence be $u_{[o,n]}$ wherein:

$$u_{[o,n]} = [u_{01}, u_{02}, u_{11}, u_{12}, u_{21}, u_{22}, u_{31}, u_{32}, \dots, u_{n1}, u_{n2}] \qquad (3)$$

Let the encoded sequence be $v_{[o,n]}$ wherein:

$$v_{[o,n]} = [v_{01}, v_{02}, v_{03}, v_{11}, v_{12}, v_{13}, v_{21}, v_{22}, v_{23}, v_{31}, v_{32}, v_{33}, \dots, v_{n1}, v_{n2}, v_{n3}] \qquad (4)$$

The received sequence $v^{\wedge}_{[0,n]}$ (reference 105 in Fig. 1) will be correct if the following equation will be satisfied:

$$v^{\wedge}_{[0,n]} \cdot H^T = 0 \qquad (5)$$

In order that all information bits are protected from corresponding parity bits it is necessary to impose the following condition:

$$h_1^{(0)}(n)=1, h_2^{(0)}(n)=1, h_1^{(0)}(n)=1 \Rightarrow n = 0,1,2,\dots (6)$$

The systematic LDPC-CC encoding device 111 will execute encoding by implementing the following equations:

$$\begin{cases} v_{n1} = u_{n1}, v_{n2} = u_{n2} \\ v_{n3} = \sum_{i=0}^{M} h_1^{(i)}(n) \cdot u_{(n-i)1} + \sum_{i=0}^{M} h_2^{(i)}(n) \cdot u_{(n-i)2} + \sum_{i=0}^{M} h_3^{(i)}(n) \cdot u_{(n-i)3} \end{cases} \qquad (7)$$

The LDPC Convolutional Codes (LDPC-CC) have been compared with the conventional FEC classes such as Convolutional Turbo Codes (CTC) and LDPC block codes (LDPC-BC); see, for example, in T. Kishigami, Y. Murakami, I. Yoshii: "LDPC Convolutional Codes for IEEE 802.16m FEC Scheme", IEEE 802.16 Broadband Wireless Access Working Group. From the result of the comparison the LDPC-CCs have advantages of encoder complexity and decoder latency: performances of LDPC-CC are as good as performances of LDPC-BC and CTC; LDPC-CC have the major advantage in enabling the decoding device 121 to adopt parallel decoding process as compared with CTC; and LDPC-CC have advantages of encoder complexity and decoding latency as compared with LDPC-BC.

Because of tail-biting, increasing the code period number that is increasing the code word length, the rates of the TB-LDPC-CC (tail-biting LDPC convolutional codes) tend asymptotically to the construction rate of the LDPC-CC that is R=b/c=2/3.

The binary parity-check matrix construction for LDPC-CC, as shown in Alberto Jimenez Felstrom, Kamil Zigangirov: "Time-varying periodic convolutional codes with low density parity-check matrix", IEEE Trans. Information Theory 45 (6): 2181-2191 (1999), has the following properties: it has not column weight equal to "1"; the row layered decoding, already used in LDPC-BC, cannot be used. Further, a serial layered decoding, which decodes the same information sequence, leads to good performances (fast convergence of the belief propagation algorithm) but high latency. A parallel layered decoding, which decodes the same information sequence, leads to not good performances (slow convergence of the belief propagation algorithm) but low latency. Moreover, a parallel layered decoding, which decodes a different information sequence, leads to good performances (fast convergence of the belief propagation algorithm) but high latency.

In addition the binary parity-check matrix construction for LDPC-CC as shown in Alberto Jimenez Felstrom, Kamil Zigangirov: "Time-varying periodic convolutional codes with low density parity-check matrix", IEEE Trans. Information Theory 45 (6): 2181-2191 (1999), is very exposed to 4-length cycles (as it is possible easily to verify by looking at the matrixes in table 1 and in table 2) which determine a performance degradation for the LDPC- CC

```
1 1 1 1 1 1 1 0 0 0 0 0 0 0 0 0 0 0 0 0 0
0 0 0 1 1 1 0 1 1 1 1 1 1 1 0 0 0 0 0 0 0
0 1 1 0 1 0 0 1 0 0 0 0 0 0 1 1 1 1 1 1 1
1 0 1 0 0 0 0 0 0 1 1 0 0 0 0 1 0 1 1 0 0
0 1 0 1 0 0 0 0 1 1 0 1 0 0 0 0 1 0 0 0 0
1 0 0 0 0 1 0 1 1 0 0 0 1 0 0 1 0 0 0 1 0
0 0 0 0 0 0 1 0 0 0 1 1 1 0 1 0 0 0 1 0 0
0 0 0 0 0 0 0 0 0 0 0 0 0 1 1 0 1 1 0 1 0
0 0 0 0 0 0 0 0 0 0 0 0 0 0 0 0 0 0 0 0 1
0 0 0 0 0 0 0 0 0 0 0 0 0 0 0 0 0 0 0 0 0
```

table 1) Binary parity-check matrix for LDPC-CC$_1$ with rate Rl=bl/cl=6/7 (Binary matrix portion: rows 1-10 and columns 1-21)

```
1 1 1 1 1 1 1 1 0 0 0 0 0 0 0 0 0 0 0 0 0 0 0 0
1 1 0 0 0 1 0 0 1 1 1 1 1 1 1 1 0 0 0 0 0 0 0 0
0 0 1 1 0 1 0 0 1 0 0 1 0 0 1 0 1 1 1 1 1 1 1 1
0 1 1 0 1 0 0 0 0 0 1 0 1 0 0 0 0 1 0 1 1 0 0 0
1 0 0 0 1 0 1 0 1 0 0 0 1 1 0 0 1 0 0 0 0 1 1 0
0 0 0 1 0 0 1 0 0 1 1 1 0 0 0 0 0 0 1 0 1 1 0 0
0 0 0 0 0 0 0 1 0 1 0 0 0 1 1 0 0 0 1 1 0 0 1 0
0 0 0 0 0 0 0 0 0 0 0 0 0 0 0 0 1 1 1 0 0 0 0 0
0 0 0 0 0 0 0 0 0 0 0 0 0 0 0 0 0 0 0 0 0 0 0 1
0 0 0 0 0 0 0 0 0 0 0 0 0 0 0 0 0 0 0 0 0 0 0 0
```

table 2) Binary parity-check matrix for LDPC-CC2 with rate R2=b2/c2=7/8 (Binary matrix portion: rows 1-10 and columns 1-24)

Consequently, further encoding and/or decoding methods are required that overcome the above-mentioned drawbacks.

US20160173132A1 discloses protograph construction methods for generating convolutional LDPC code matrices in which multi-equation problems of girth maximization are reduced or replaced using other techniques including (with limitation): finding base matrices with a unique set of non-repeating distance parameters, finding the minimum largest such distance parameter among solution-set matrices, and quasi-cyclic lifting of the generated convolutional LDPC code matrix. 4-cycles and select (avoidable) 6-cycles are thereby removed from the resulting convolutional LDPC code matrix, thereby resulting in significant performance gains. Document ZHENGANG CHEN ET AL: "Jointly Designed Architecture-Aware LDPC Convolutional Codes and High-Throughput Parallel Encoders/Decoders", IEEE TRANSACTIONS ON CIRCUITS AND SYSTEMS I: REGULAR PAPERS, IEEE, US, vol. 57, no. 4, proposes a design approach for low-density parity-check convolutional codes (LDPC-CCs), that jointly optimizes the code, encoder and decoder to achieve high-throughput parallel encoding and decoding. A series of implementation-oriented constraints are applied to construct architecture-aware (AA) codes by introducing algebraic structures into the parity-check matrix. The resulting AA codes have bit error rate performance comparable to other published LDPC-CCs. Given these AA LDPC-CCs, new architectures are proposed for a parallel LDPC-CC encoder with built-in termination and an LDPC-CC decoder that is parallel in the node dimension as well as pipelined in the iteration dimension.

Document CHUN-HAO LIAO ET AL: "An IP generator for quasi-cyclic LDPC convolutional code decoders", CIRCUITS AND SYSTEMS, 2008. APCCAS 2008. IEEE ASIA PACIFIC CONFERENCE ON, IEEE, PISCATAWAY, NJ, USA presents the design and implementation of a high performance soft LDPC-CC decoder IP generator. The proposed design is based on quasi-cyclic (QC) low-density parity-check matrices. A special digital processor is proposed to reduce the critical path and enhance the throughput. In addition, an IP generator and associated user interface is proposed that can take specifications of three parameters: iteration number, memory length, and code rate.

SUMMARY

The object of the present invention is to provide improved information decoding. Particularly, the object of the present invention is to provide information decoding that overcomes at least some of the above-mentioned drawbacks.

The object of the present invention is achieved by the solution provided in the enclosed independent claims. Advantageous implementations of the present invention are further defined in the respective dependent claims, in the description, and/or in the appended figures. In the following, parts of the description and drawings referring to embodiments which are not covered by the claims are not presented as embodiments of the invention, but as examples useful for understanding the invention.

According to a first aspect, a seed matrix generator is provided to be used for encoding an information and/or for decoding an encoded information, wherein the seed matrix generator is arranged to generate a seed matrix, the seed matrix being a binary parity check matrix of at least one low-density parity-check convolutional code, LDPC-CC.

In a first possible implementation according to the first aspect, the seed matrix generator if further configured to: mask a full exponent matrix of rate R with the generated seed matrix of a rate R; and expand the masked full exponent matrix with a spreading matrix to generate a cycle-free binary parity check matrix. In an embodiment, the seed matrix is a seed matrix of a LDPC convolutional turbo code, LDPC-CTC.

In a second possible implementation form according to the first aspect as such or according to the first implementation form of the first aspect, the seed matrix generator is arranged to generate the seed matrix by: generating w auxiliary seed matrices for w parallel LDPC-CCs, wherein each one of the w auxiliary seed matrices is generated for one of the w parallel LDPC-CCs, wherein w is a positive integer; and interlacing the generated w auxiliary seed matrices of the w parallel LDPC-CCs to generate the seed matrix of the LDPC-CTC.

In a third possible implementation form according to the second possible implementation form of the first aspect: for each j-th auxiliary seed matrix, j being a positive integer that is smaller than w, a parity sequence of a j-th auxiliary seed matrix of a j-th LDPC-CC is input as information sequence in a (j+1)-th auxiliary seed matrix of a (j+1)-th LDPC-CC; and each LDPC-CC of the w LDPC-CCs is generated with a corresponding code rate $R_\beta$ that is different from the code rates of the further LDPC-CCs of the w LDPC-CC, wherein $\beta$ is a positive integer and $1 \leq \beta \leq w$.

In a fourth possible implementation form according to the third possible implementation form of the first aspect, the corresponding code rate $R_\beta$ is determined by the following equation:

$$ R_\beta = \frac{(w \cdot b - 1) + \beta}{w \cdot (c - 1) + \beta}, $$

wherein the information is a sequence of information bits and b is a number of the information bits of the sequence, and wherein the encoded information is a sequence of encoded bits and c is a number of the encoded information bits.

In a fifth possible implementation form according to the second, third or fourth possible implementation form of the first aspect, the seed matrix generator is configured to execute the interlacing by arranging rows of matrices of the w LDPC-CC codes as rows of the seed matrix of the LDPC-CTC.

In a sixth possible implementation form according to the second, third, fourth, or fifth possible implementation form of the first aspect, the seed matrix generator is configured to execute the interlacing by arranging consecutively all i-th rows of the w LDPC-CC codes as rows in the seed matrix of the LDPC-CTC, wherein i is a positive integer and is less than or equal to the number of rows of a LDPC-CC code of the w LDPC-CC codes.

In a seventh possible implementation form according to the sixth possible implementation form of the first aspect, the i-th rows of the w LDPC-CC codes are followed by consecutively arranged i+1-th rows of the w LDPC-CC codes in the seed matrix of the LDPC-CTC.

According to a second aspect, a seed matrix generation method is provided to be used for encoding an information and/or for decoding an encoded information, wherein the seed matrix generation method comprises generating a seed matrix, the seed matrix being a binary parity check matrix of at least one low-density parity-check convolutional code, LDPC-CC. The seed matrix generation method is generally arranged to include any one or any combination of the steps executed by the seed matrix generator considered and described herein.

According to a third aspect, an encoding device is provided that is arranged to execute an encoding of an information being a sequence of information bits, said encoding device comprising a seed matrix generator configured to generate a seed matrix that is arranged to be used for the encoding of the information and being a seed matrix generator described herein.

In a first possible implementation according to the third aspect, the encoding device further comprises: an exponent parity check matrix generator configured to generate an exponent parity check matrix, wherein an initial exponent parity check matrix is masked by the seed matrix to generate the exponent parity-check matrix; and an encoder configured to encode the information by use of the generated exponent parity check matrix.

According to a fourth aspect, an encoding method is provided that is configured to execute an encoding of an information being a sequence of information bits, said encoding method comprising a step of seed matrix generation for generating a seed matrix that is arranged to be used for the encoding of the information, and said step of seed matrix generation being executed by use of the seed matrix generation method described herein. The encoding method is generally arranged to comprise any one or any combination of steps executed by the encoding device described herein.

In a first possible implementation according to the fourth aspect, the encoding method further comprises: a step of exponent parity check matrix generation for generating an exponent parity check matrix, wherein an initial exponent parity check matrix is masked by the seed matrix to generate the exponent parity-check matrix; and a step of encoding the information by use of the generated exponent parity check matrix.

In a fifth aspect, a decoding device is provided that is arranged to execute a decoding of an encoded information being a sequence of encoded information bits, said decoding device comprising a seed matrix generator configured to generate a seed matrix that is arranged to be used for the decoding of the information and being a seed matrix generator described herein.

In a first possible implementation according to the fifth aspect, the decoding device further comprises: an exponent parity check matrix generator configured to generate an exponent parity check matrix, wherein an initial exponent parity check matrix is masked by the seed matrix to generate the exponent parity-check matrix; a binary parity-check matrix generator configured to generate a binary parity-check matrix, wherein the binary parity-check matrix is obtained by expanding the generated exponent parity-check matrix by means of a spreading matrix; and a decoder configured to decode the encoded information by use of the binary parity-check matrix.

In a second possible implementation according to the first possible implementation of the fifth aspect, the spreading matrix is a cyclic permutation matrix of an identity matrix.

In a sixth aspect, a decoding method is provided that is configured to execute an decoding of an encoded information being a sequence of encoded information bits, said decoding method comprising a step of seed matrix generation for generating a seed matrix that is arranged to be used for the decoding of the encoded information, and said step of seed matrix generation being executed by use of the seed matrix generation method described herein. The decoding method is generally arranged to comprise any one or any combination of steps executed by the decoding device described herein.

In a first possible implementation according to the sixth aspect, the decoding method further comprises: a step of exponent parity check matrix generation for generating an exponent parity check matrix, wherein an initial exponent parity check matrix is masked by the seed matrix to generate the exponent parity-check matrix; a step of binary parity-check matrix generation for generating a binary parity-check matrix, wherein the binary parity-check matrix is obtained by expanding the generated exponent parity-check matrix by means of a spreading matrix; and a step of decoding for decoding the encoded information by use of the binary parity-check matrix.

In a second possible implementation according to first possible implementation of the sixth aspect, the spreading matrix is a cyclic permutation matrix of an identity matrix.

In a seventh aspect, a computer program product is provided. The computer program product includes code for performing the steps on the seed matrix generation method according to claim 9, and/or the encoding method of claim 12 or 13, or the decoding method of any one of claims 17 to 19.

BRIEF DESCRIPTION OF DRAWINGS

The above-described aspects and implementation forms of the present invention will be explained in the following description of specific embodiments in relation to the enclosed drawings, in which

Fig. 1     shows an example of a conventional communication system model.

Fig. 2     shows a transposed parity-check matrix, called syndrome matrix, of a periodical convolutional code.

Fig. 3     shows a transposed parity-check matrix, called syndrome matrix, of a periodical binary convolutional code.

Fig. 4a     shows an arrangement of an encoding device according to an embodiment of the present invention.

Fig. 4b     shows a further arrangement of an encoding device according to an embodiment of the present invention.

Fig. 5a    shows steps of an encoding method according to an embodiment of the present invention.

Fig. 5b    shows steps of an encoding method according to a further embodiment of the present invention.

Fig. 6a    shows an arrangement of a decoding device according to an embodiment of the present invention.

Fig. 6b    shows a further arrangement of a decoding device according to an embodiment of the present invention.

Fig. 7a    shows steps of a decoding method according to an embodiment of the present invention.

Fig. 7b    shows steps of a decoding method according to a further embodiment of the present invention.

Fig. 8    shows sub-steps of the step of seed matrix generation according to an embodiment of the present invention.

Fig. 9    shows sub-steps of the sub-step of generating $w$ auxiliary seed matrices for $w$ parallel LDPC-CCs according to an embodiment of the present invention.

Fig. 10    shows a more concrete arrangement of the encoding device according to an embodiment of the present invention.

Fig. 11    shows a more concrete arrangement of the encoding device according to an embodiment of the present invention.

Fig. 12    shows a portion of a generated seed matrix for LDPC-CTC according to an embodiment of the present invention.

DETAILED DESCRIPION OF EMBODIMENTS

Generally, it has to be noted that all arrangements, devices, modules, components, models, elements, units, entities, and means and so forth described in the present application could be implemented by software or hardware elements or any kind of combination thereof. All steps which are performed by the various entities described in the present application as well as the functionality described to be performed by the various entities are intended to mean that the respective entity is adapted to or configured to perform the respective steps and functionalities. Even if in the following description of the specific embodiments, a specific functionality or step to be performed by a general entity is not reflected in the description of a specific detailed element of the entity which performs the specific step or functionality, it should be clear for a skilled person that these methods and functionalities can be implemented in respective hardware or software elements, or any kind of combination thereof. Further, the method of the present invention and its various steps are embodied in the functionalities of the various described apparatus elements.

Moreover, any of the embodiments and features of any of the embodiments, described herein, may be combined with each other, unless a combination is explicitly excluded.

The communication system model, in which the present invention may be implemented, may be, for example, based on the communication system model shown in Fig. 1. The present invention focuses, generally, on the arrangement of the encoding device 111 and/or on the arrangement of the decoding device 121 and replaces the conventional encoding device 111 and/or decoding device 121 as shown exemplary in Fig. 1.

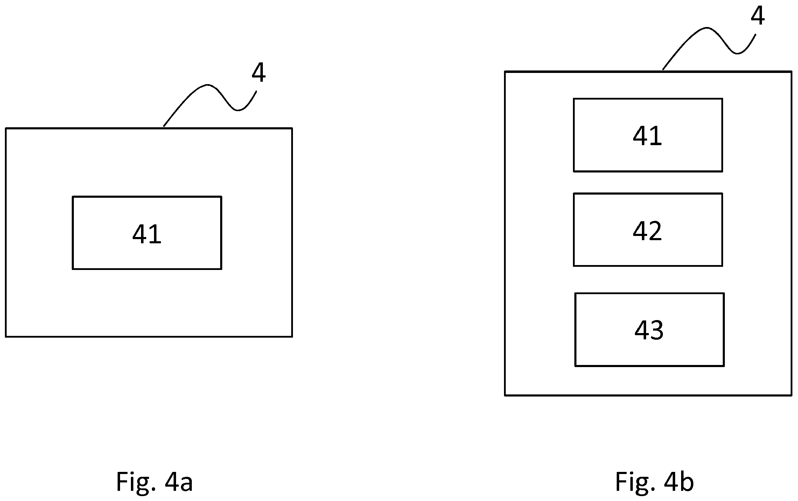

Fig. 4a shows an arrangement of an encoding device 4 according to an embodiment of the present invention. The encoding device 4 comprises a seed matrix generator 41 configured to generate a seed matrix that is arranged to be used for encoding information 101 and/or for decoding encoded information 105. With regard to the embodiment of Fig. 4a, the seed matrix is arranged to be used at least for encoding information 101. According to an embodiment, binary parity check matrix of a low-density parity-check convolutional code (LDPC-CC) is used as seed matrix. Conventionally, the binary parity check matrix is directly used to perform decoding process. However, said binary parity check matrix is not cycle free. Therefore, the performance of the decoder are degraded. The present invention is based on the observation that using the binary parity check matrix of the LDPC-CC as seed matrix allows building a binary parity check matrix, which is cycle free. Using a cycle free binary parity check matrix allows to have better performances than that of the state of the art devices.

In an embodiment, a full exponent matrix is masked with the generated seed matrix and the masked full exponent matrix is expanded with a spreading matrix to generate the cycle-free binary parity check matrix.

The seed matrix and its role in encoding and/or decoding processes is generally known. A seed matrix is an initial matrix, starting from which the matrix actually used for encoding and/or decoding purposes is generated. The matrix actually used for encoding and/or decoding purposes is grown or built respectively on the basis of the seed matrix.

According to the present embodiment, the seed matrix is generated by the seed matrix generator 41 based on at least one low-density parity-check convolutional code (LDPC-CC). Specifically, the seed matrix is a binary parity check matrix of at least one low-density parity-check convolutional code, LDPC-CC. The LDPC-CC may for instance be the convolutional code as proposed in Alberto Jimenez Felstrom, Kamil Zigangirov: "Time-varying periodic convolutional codes with low density parity-check matrix".

The seed matrix is, according to an embodiment of the present invention, particularly a seed matrix of a LDPC convolutional turbo code (LDPC-CTC). In this way, the advantages of the LDPC-CTC can be adopted. For example, the advantage of an improved performance is adopted.

The arrangement and the implementation of the seed matrix generator 41 will be explained in more detail below.

Fig. 4b shows a further arrangement of an encoding device 4 according to an embodiment of the present invention. The embodiment of Fig. 4b is based on the embodiment of Fig. 4a. According to the embodiment of Fig. 4b, the encoding device 4 comprises further an exponent parity check matrix generator 42 configured to generate an exponent parity check matrix, wherein an initial exponent parity check matrix is masked by the seed matrix to generate the exponent parity-check matrix. Additionally, according to the embodiment of Fig. 4b, the encoding device 4 comprises an encoder 43 configured to encode the information 101 by use of the exponent parity check matrix. Via the encoding 43, encoded information 102 is obtained.

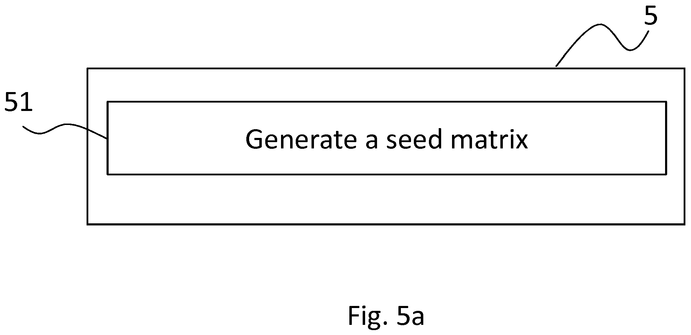

Fig. 5a shows steps of an encoding method 5 according to an embodiment of the present invention. The steps of the encoding method 5 are executed, for example, by the above-mentioned encoding device 4. According to the present embodiment, the encoding method 5 comprises a step 51 of seed matrix generation for generating 51 a seed matrix that is arranged to be used for the encoding of the information. Said step 51 of seed matrix generation is cxccutcd, according to an embodiment, by the seed matrix generator 41. As seed matrix a binary parity check matrix of at least one low-density parity-check convolutional code, LDPC-CC is taken.

According to an embodiment, the seed matrix is used as a mask matrix between the full exponent parity-check matrix and the generated exponent parity-check matrix.

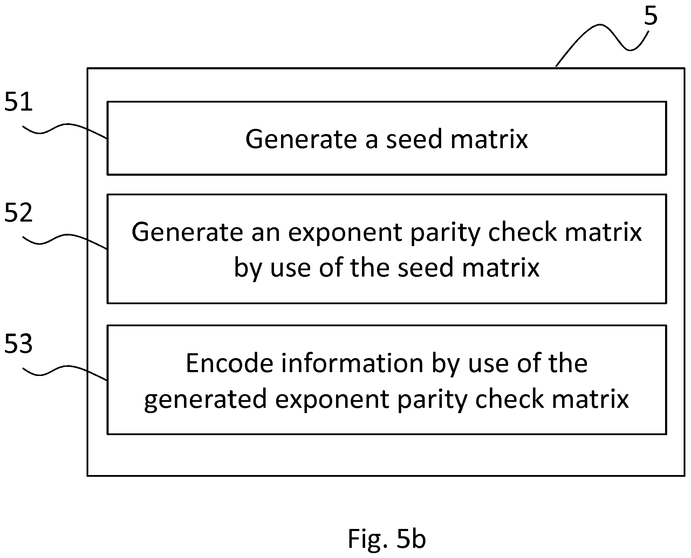

Fig. 5b shows steps of an encoding method 5 according to a further embodiment of the present invention. The embodiment of Fig. 5b is based on the embodiment of Fig. 5a. According to the embodiment of Fig. 5b, the encoding method 5 further comprises a step 52 of exponent parity check matrix generation for generating an exponent parity check matrix, wherein an initial exponent parity check matrix is masked by the seed matrix to generate 52 the exponent parity-check matrix. According to an embodiment, the step 52 of exponent parity check matrix generation is executed by the exponent parity check matrix generator 42. Further, according to the embodiment of Fig. 5b, the encoding method 5 comprises a step 53 of encoding the information 101 by use of the generated 52 exponent parity check matrix. According to an embodiment, the step 53 of encoding the information 101 is executed by the encoder 43.

According to an embodiment of the present invention (combinable with any one of the embodiments described herein), the step 51 and/or the step 52, i.e. the steps of seed matrix generation 51 and/or of the exponent parity check matrix generation 52 are executed offline. In this way, hardware complexity is reduced. The generation 51, 52 of the respective matrices requires computational time and hardware. When the respective matrices are generated in advance, i.e. offline, during the execution of the encoding 5, for example, the generation 51, 52 of the respective matrices online is not necessary. During the encoding 5, the respective matrices, generated 51, 52 (in advance) offline, can be used. This leads to computational time saving and hardware saving. Consequently, a more efficient encoding 5 is enabled.

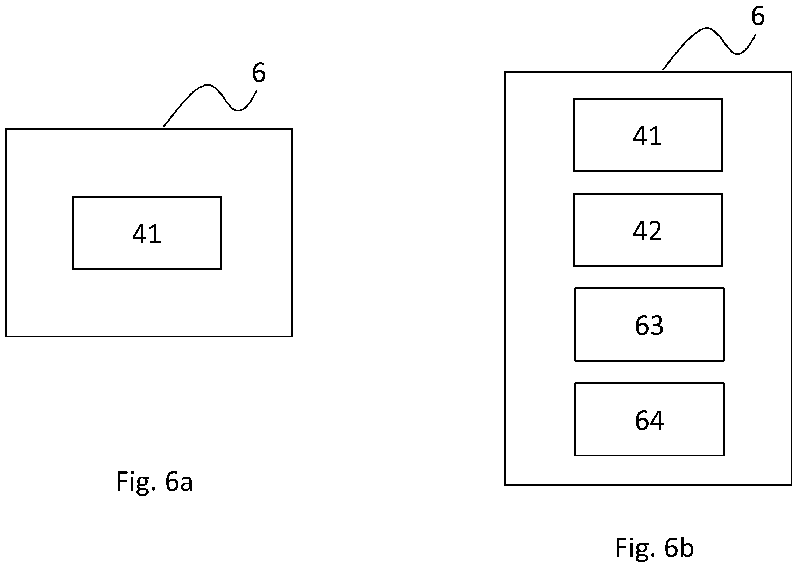

Fig. 6a shows an arrangement of a decoding device 6 according to an embodiment of the present invention. The decoding device 6 also comprises the seed matrix generator 41 configured to generate a seed matrix that is arranged to be used for encoding information 101 and/or for decoding encoded information 105. With regard to the embodiment of Fig. 6a, the seed matrix is arranged to be used at least for decoding encoded information 105.

Fig. 6b shows a further arrangement of a decoding device 6 according to an embodiment of the present invention. The embodiment of Fig. 6b is based on the embodiment of Fig. 6a. According to the embodiment of Fig. 6b, the decoding device 6 comprises further the exponent parity check matrix generator 42 configured to generate an exponent parity check matrix, wherein an initial exponent parity check matrix is masked by the seed matrix to generate the exponent parity-check matrix. Additionally, according to the embodiment of Fig. 6b, the decoding device 6 comprises a binary parity-check matrix generator 63 configured to generate a binary parity-check matrix, wherein the binary parity-check matrix is obtained by expanding the generated exponent parity-check matrix by means of a spreading matrix. According to an embodiment, the spreading matrix is a cyclic permutation matrix of an identity matrix. Furthermore, according to the embodiment of Fig. 6b, the decoding device 6 comprises a decoder 64 configured to decode the encoded information 105 by use of the binary parity-check matrix. Via the decoding 64, decoded information 106 is obtained. The decoded information 106 is an estimate of the original information 101.

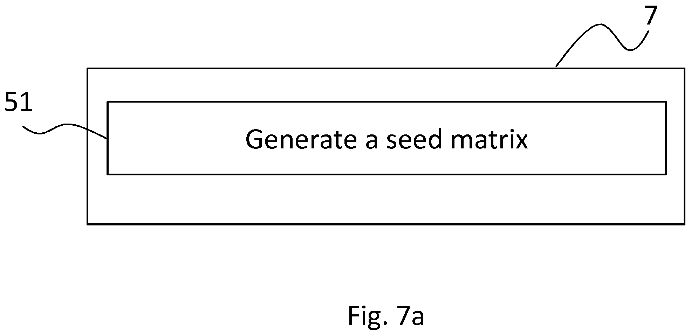

Fig. 7a shows steps of a decoding method 7 according to an embodiment of the present invention. The steps of the decoding method 7 are executed, for example, by the above-mentioned decoding device 6. According to the present embodiment, the decoding method 7 comprises the step of seed matrix generation 51 for generating a seed matrix that is arranged to be used for the encoding 43, 53 of the information. Said step of seed sequence generation 51 is executed, according to an embodiment, by the seed matrix generator 41. According to an embodiment, the seed matrix is a mask matrix between the full exponent parity-check matrix and the generated exponent parity-check matrix.

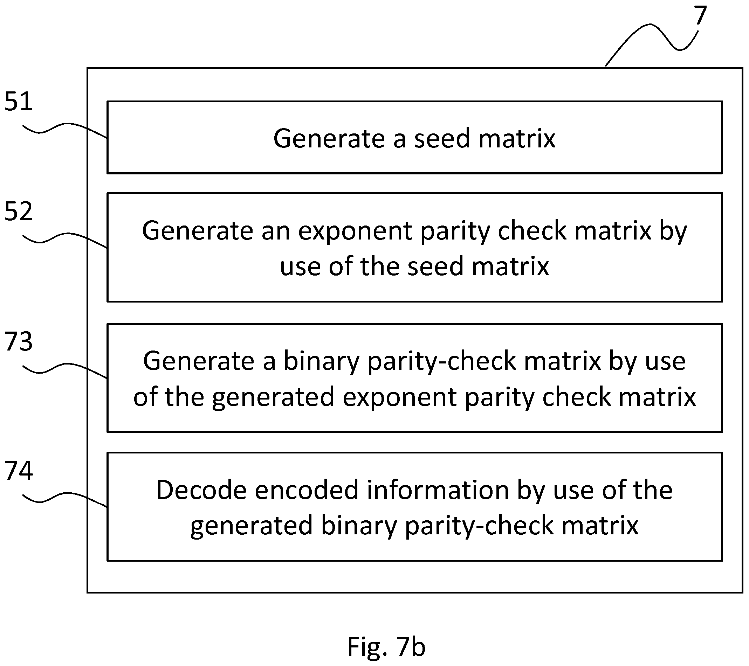

Fig. 7b shows steps of a decoding method 7 according to a further embodiment of the present invention. The embodiment of Fig. 7b is based on the embodiment of Fig. 7a. According to the embodiment of Fig. 7b, the decoding method 7 further comprises the step of exponent parity check matrix generation 52 for generating an exponent parity check matrix, wherein an initial exponent parity check matrix is masked by the seed matrix to generate the exponent parity-check matrix. According to an embodiment, the step of exponent parity check matrix generation 52 is executed by the exponent parity check matrix generator 42. Additionally, according to the embodiment of Fig. 7b, the decoding method 7 comprises a step 73 of binary parity-check matrix generation for generating a binary parity-chcck matrix, wherein the binary parity-chcck matrix is obtained by expanding the generated exponent parity-check matrix by means of a spreading matrix. According to an embodiment, the spreading matrix is a cyclic permutation matrix of an identity matrix. The step 73 of binary parity-check matrix generation is executed, for example, by the binary parity-check matrix generator 63. Further, according to the embodiment of Fig. 7b, the decoding method 7 comprises a step 74 of decoding the information 105 by use of the generated binary parity-check matrix. According to an embodiment, the step 74 of decoding the information 105 is executed by the decoder 64. Via the decoding 74, decoded information 106 is obtained. The decoded information 106 is an estimate of the original information 101.

As mentioned above, according to an embodiment of the present invention (combinable with any one of the embodiments described herein), the step 51 and/or the step 52 and/or step 73, i.e. the steps of seed matrix generation 51 and/or of the exponent parity check matrix generation 52 and/or of the binary parity-check matrix generation 73 are executed offline. In this way, hardware complexity is reduced. When the respective matrices are generated in advance, i.e. offline, during the execution of the decoding 7, for example, the generation 51, 52, 73 of the respective matrices online is not necessary. During the decoding 7, the respective matrices, generated 51, 52, 73 (in advance) offline, can be used. This leads to computational time saving and hardware saving. Consequently, a more efficient decoding 7 is enabled.

As mentioned, according to an embodiment, the seed matrix generator 41 is configured to generate a seed matrix of LDPC-CTC.

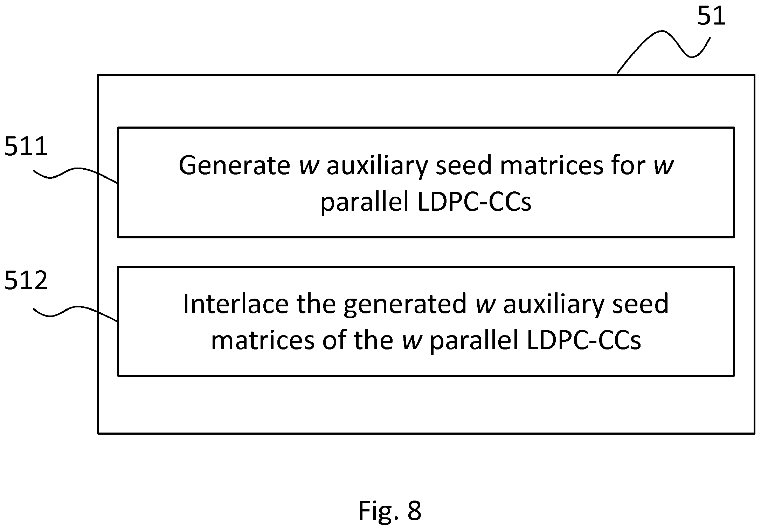

Further, according to an embodiment, the seed matrix generator 41 is configured to generate the seed matrix by executing the steps shown in Fig. 8.

Particularly, Fig. 8 shows sub-steps of the step 51 of seed matrix generation according to an embodiment of the present invention.

According to the embodiment of Fig. 8, the step 51 of seed matrix generation comprises a sub-step 511 of generating w auxiliary seed matrices for w parallel LDPC-CCs, wherein each one of the w auxiliary seed matrices is generated for one of the w parallel LDPC-CCs, wherein $w$ is a positive integer. Further, according to the embodiment of Fig. 8, the step 51 of seed matrix generation comprises a sub-step 512 of interlacing the generated w auxiliary seed matrices of the w parallel LDPC-CCs to build the seed matrix of the LDPC-CTC.

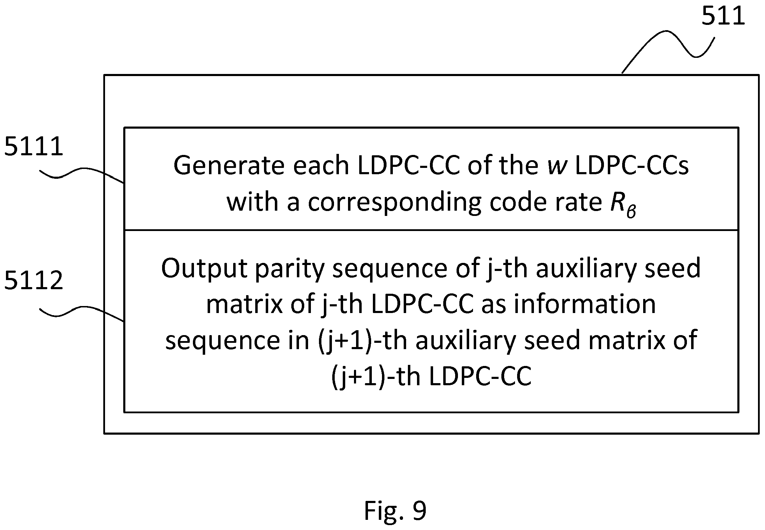

Fig. 9 shows sub-steps of the sub-step 511 of generating $w$ auxiliary seed matrices for $w$ parallel LDPC-CCs according to an embodiment of the present invention. Of course, according to an embodiment, the sub-steps of Fig. 9 are executed by the seed matrix generator 41.

According to Fig. 9, in sub-step 5111, each LDPC-CC of the w LDPC-CCs is generated with a corresponding code rate $R_\beta$ that is different from the code rates of the further LDPC-CCs of the w LDPC-CC, wherein $\beta$ is a positive integer and $1 \leq \beta \leq w$. In sub-step 5112, for each j-th auxiliary seed matrix, j being a positive integer that is smaller than w, parity sequence of j-th auxiliary seed matrix of j-th LDPC-CC is input as information sequence in (j+1)-th auxiliary seed matrix of (j+1)-th LDPC-CC.

According to an embodiment, the corresponding code rate $R_\beta$ is determined by the following equation:

$$R_\beta = \frac{(w \cdot b - 1) + \beta}{w \cdot (c - 1) + \beta},$$

wherein the information is a sequence of information bits and $b$ is a number of the information bits of the sequence, and wherein the encoded information is a sequence of encoded bits and $c$ is a number of the encoded information bits.

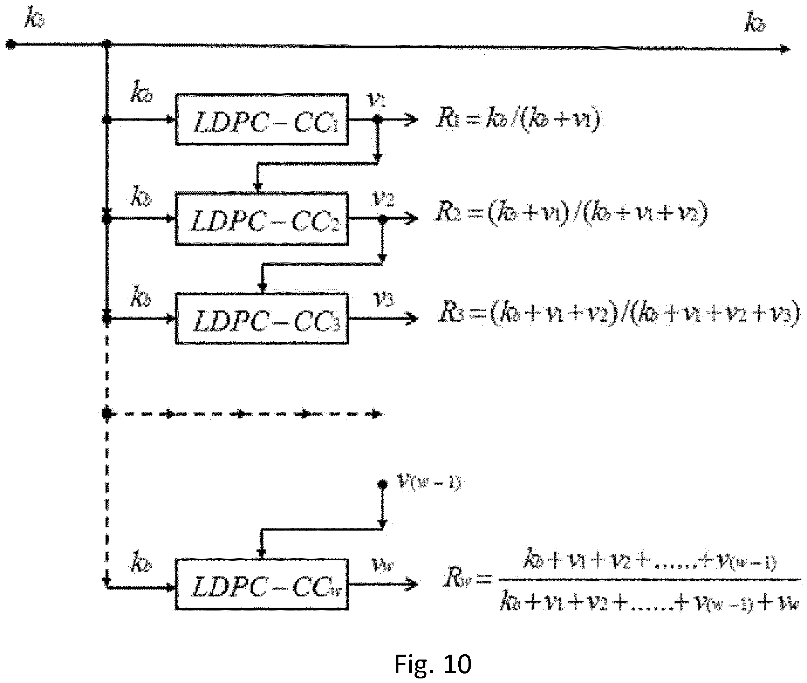

Fig. 10 shows sub-steps of the sub-step 512 of interlacing the generated $w$ auxiliary seed matrices of the w parallel LDPC-CCs to build the seed matrix of the LDPC-CTC according to an embodiment of the present invention. Of course, according to an embodiment, the sub-steps of Fig. 10 are executed by the seed matrix generator 41.

The interlacing 512 is executed, according to an embodiment, by arranging rows of matrices of the w LDPC-CC codes as rows of the seed matrix of the LDPC-CTC. Particularly, according to an embodiment the interlacing is executed by arranging consecutively all i-th rows of the w LDPC-CCs as rows in the seed matrix of the LDPC-CTC, wherein i is a positive integer and is less than or equal to the number of rows of a LDPC-CC code of the w LDPC-CC codes. According to a further embodiment, the i-th rows of the w LDPC-CC codes are followed by consecutively arranged i+1-th rows of the w LDPC-CC codes in the seed matrix of the LDPC-CTC.

The invention described herein overcomes at least some of the above-mentioned drawbacks of the known encoding and/or decoding methods by generating a seed matrix for LDPC-CTC interlacing at least two (i.e. two or more) binary parity-check matrices of the LDPC-CC. The LDPC-CC are arranged, according to an embodiment, as described, for example, in Alberto Jimenez Felstrom, Kamil Zigangirov: "Time-varying periodic convolutional codes with low density parity-check matrix", IEEE Trans. Information Theory 45 (6): 2181-2191 (1999), built with (or without) concatenated parity.

According to an embodiment, the LDPC-CTC comprises a non-concatenated parity sequence. In this case, all w LDPC-CC codes have the same code rate. For example, in the case of two parallel LDPC-CCs (*w*=2), 6 information bits and one parity bit are present resulting in a code rate R1=R2=6/7 for each code. In the case of non-concatenated codes, 6 information bits and two parity bits (one for each LDPC-CC code) are present. Thus, the total code rate of the LDPC-CTC will be R=b/c=6/8=3/4.

In the description, it is sometimes focused exemplary on the LDPC-CTC with concatenated parity because LDPC-CTCs are codes enabling a better performance.

According to the present invention, a seed matrix for a specific rate R, built as described herein, masked with a full exponent matrix for a rate R and expanded with a spreading matrix (e.g., cyclic permutation matrix) produces a binary parity-check matrix for the LDPC-CTC, which leads to significant performance gains.

With the invention, as described herein, it is possible to carry-out the parallel layered decoding 64, 74 with good performances (fast convergence of the belief propagation algorithm) and low decoding latency.

The LDPC-CTC does not use an interleaver circuit because such operation is carried-out from the spreading matrixes with different exponent value for each parallel path (two or more).

The skilled in the art will find the tradeoff between the wished performances and the parallel concatenated LDPC-CC number for keeping hardware complexity low.

The spreading matrix is, for example, a square binary matrix of weight equal to *"1"* and size $Z_f \times Z_f$, wherein $Z_f$ is the spreading factor, which is tied to the code word length of the carried-out LDPC code.

If the spreading factor $Z_f = 48$ is chosen, for example, then the full exponent matrix $E_{exp}$ will have elements (exponents) comprised between *0* and $(Z_f - 1) = 47$.

The exponent matrix elements with values comprised between 0 and $(Z_f-1)$ represent cyclic permutation matrixes of the identity matrix (with weight equal to "1" for each row and for each column) with size $Z_f \times Z_f$.

The value of the exponent matrix element indicates a cyclic shift to the right of the identity matrix, as shown in the matrixes $I_{Z_f}^{[0]}, I_{Z_f}^{[1]}, ..., I_{Z_f}^{[Z_f-1]}$ below. All non-negative exponent matrix elements have meaning, for example the zero exponent permutation matrix corresponds to the identity matrix.

$$I_{Z_f}^{[0]} = \begin{bmatrix} 1 & 0 & 0 & 0 & . & 0 & 0 & 0 \\ 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \\ 0 & 0 & 0 & 0 & . & 0 & 0 & 1 \end{bmatrix} \qquad I_{Z_f}^{[1]} = \begin{bmatrix} 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \\ 0 & 0 & 0 & 0 & . & 0 & 0 & 1 \\ 1 & 0 & 0 & 0 & . & 0 & 0 & 0 \end{bmatrix}$$

$$I_{Z_f}^{[Z_f-1]} = \begin{bmatrix} 0 & 0 & 0 & 0 & . & 0 & 0 & 1 \\ 1 & 0 & 0 & 0 & . & 0 & 0 & 0 \\ 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \end{bmatrix}$$

Each element of the exponent matrix of value "-1" conventionally represents a null square matrix of size ZfxZf as shown in matrix $I_{Z_f}^{[-1]}$ :

$$I_{Z_f}^{[-1]} = \begin{bmatrix} 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \\ . & . & . & . & . & . & . & . \\ 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \end{bmatrix}$$

The skilled person easily understands that same benefits may be obtained if the cyclic shift is a cyclic shift to the left instead than a one to the right.

In the following a more concrete embodiment of the present invention is presented, wherein the more concrete embodiment is based on the above-explained embodiments and, thus, supplements the above-explained embodiments. Further, it is understood that any one or any combination of the features described below is combinable with the above presented embodiments.

According to the following embodiment, the seed matrix is generated 51 for LDPC-CTC interlacing at least two (i.e., two or more) binary parity-check matrixes of the LDPC-CC, built with concatenated parity. According to an embodiment, the LDPC-CCs are generated, as described, for example, in Alberto Jimenez Felstrom, Kamil Zigangirov: "Time-varying periodic convolutional codes with low density parity-check matrix", IEEE Trans. Information Theory 45 (6): 2181-2191 (1999), wherein the teaching on the generation of the LDPC-CCs of said publication is incorporated herein by reference.

Here, it has to be noted, that the skilled person easily understands that it is possible to build the LDPC-CTC seed matrixes without concatenated parity following the seed matrix generation procedure presented herein.

The LDPC-CTC encoder 4, with concatenated parity, is arranged, for example, as shown in Fig. 10.

The rate of an LDPC-CTC used according to the embodiment of Fig. 10 is given by:

$$R = R_1 \cdot R_2 \cdot R_3 \cdot ... \cdot R_{(w-1)} \cdot R_w = \frac{k_b}{k_b + v_1 + v_2 + \cdots + v_{(w-1)} + v_w} \tag{8}$$

In the design of the LDPC-CTC with more (e.g., two or more than two) parallel LDPC-CC it operates in this way to compute the rate of the single LDPC-CC codes.

The LDPC-CTC code, with rate $R = b / c$, is constituted by w parallel LDPC-CC codes. As mentioned above, the single LDPC-CC codes are designed with the following rates:

$$R_\beta = \frac{(w \cdot b - 1) + \beta}{w \cdot (c - 1) + \beta}, \text{ wherein } \beta = 1, 2, 3, \dots, w. \quad (9)$$

Let consider, for example, an LDPC-CTC with rate $R = b/c = 3/4$ and constituted by $w = 4$ parallel LDPC-CC; the single LDPC-CC codes have rates $R_1$, $R_2$, $R_3$, $R_{w=4}$ computed using equation (9):

$$R_\beta = \frac{(w \cdot b - 1) + \beta}{w \cdot (c - 1) + \beta}, \text{ wherein } \beta = 1, 2, 3, w = 4.$$

Thus:

$$R_1 = \frac{12}{13}, R_2 = \frac{13}{14}, R_3 = \frac{14}{15}, R_4 = \frac{15}{16}. \quad (10)$$

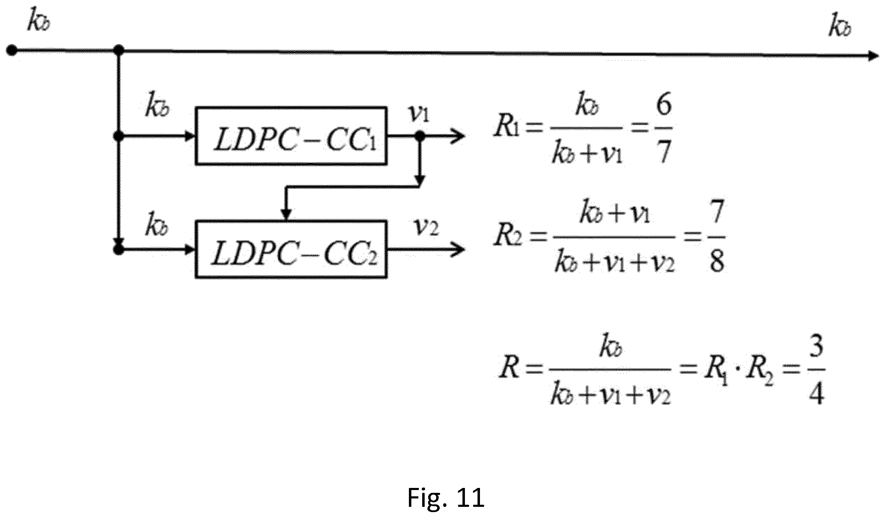

Fig. 11 shown an exemplary implementation of a LDPC-CTC encoder 4 according to an embodiment. In Fig. 11, an LDPC-CTC encoder 4 is used that has a rate $R_\beta = b/c = 3/4$, and that constituted by two ($w = 2$) parallel LDPC-CCs. The first LDPC-CC has a rate $R_1 = b_1/c_1 = 6/7$, and the second LDPC-CC has a rate $R_2 = b_2/c_2 = 7/8$, both rates being computed according to equation (9):

$$R_\beta = \frac{(w \cdot b - 1) + \beta}{w \cdot (c - 1) + \beta} = \frac{5 + \beta}{6 + \beta}, \text{ wherein } \beta = 1, w = 2. \quad (11)$$

However, also more LDPC-CCs, generated can be placed in parallel. Of course, it is necessary to find the tradeoff between the desired encoding and/or decoding performance and the complexity of hardware for the encoding 43, 53 and/or decoding 64, 74. The hardware complexity depends, for example, on the number of parallel concatenated LDPC-CCs.

When considering the embodiment of Fig. 11, where only two parallel LDPC-CCs are considered for sake of simplicity, i.e. where $w=2$, two auxiliary seed matrices are generated in step 511. The first auxiliary seed matrix has the rate of $R_1 = 6/7$, and the second auxiliary seed matrix has the rate of $R_2 = 7/8$.

In step 512, the interlacing of the two auxiliary seed matrices is executed for generating 51 the seed matrix of the LDPC-CTC. According to the present embodiment, this is accomplished by placing the first auxiliary seed matrix with the rate of $R_1 = 6/7$, arranged for interlacing (table Ibis), on the odd rows of the seed matrix of the LDPC-CTC and by placing the second auxiliary seed matrix with the rate of $R_2 = 7/8$ on the even rows of the seed matrix of the LDPC-CTC.

$$\begin{array}{cccccccccccccccccccccccc}
1 & 1 & 1 & 1 & 1 & 1 & 1 & 0 & 0 & 0 & 0 & 0 & 0 & 0 & 0 & 0 & 0 & 0 & 0 & 0 & 0 & 0 & 0 & 0 \\
0 & 0 & 0 & 1 & 1 & 1 & 0 & 0 & 1 & 1 & 1 & 1 & 1 & 1 & 1 & 1 & 0 & 0 & 0 & 0 & 0 & 0 & 0 & 0 \\
0 & 1 & 1 & 0 & 1 & 0 & 0 & 0 & 1 & 0 & 0 & 0 & 0 & 0 & 0 & 0 & 1 & 1 & 1 & 1 & 1 & 1 & 1 & 0 \\
1 & 0 & 1 & 0 & 0 & 0 & 0 & 0 & 0 & 0 & 1 & 1 & 0 & 0 & 0 & 0 & 0 & 1 & 0 & 1 & 1 & 0 & 0 & 0 \\
0 & 1 & 0 & 1 & 0 & 0 & 0 & 0 & 0 & 1 & 1 & 0 & 1 & 0 & 0 & 0 & 0 & 0 & 1 & 0 & 0 & 0 & 0 & 0 \\
1 & 0 & 0 & 0 & 0 & 1 & 0 & 0 & 1 & 1 & 0 & 0 & 0 & 1 & 0 & 0 & 0 & 1 & 0 & 0 & 0 & 1 & 0 & 0 \\
0 & 0 & 0 & 0 & 0 & 0 & 1 & 0 & 0 & 0 & 0 & 1 & 1 & 1 & 0 & 0 & 1 & 0 & 0 & 0 & 1 & 0 & 0 & 0 \\
0 & 0 & 0 & 0 & 0 & 0 & 0 & 0 & 0 & 0 & 0 & 0 & 0 & 0 & 1 & 0 & 1 & 0 & 1 & 1 & 0 & 1 & 0 & 0 \\
0 & 0 & 0 & 0 & 0 & 0 & 0 & 0 & 0 & 0 & 0 & 0 & 0 & 0 & 0 & 0 & 0 & 0 & 0 & 0 & 0 & 0 & 1 & 0 \\
0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0
\end{array}$$

table 1bis) Binary parity-check matrix for LDPC-$CC_1$ with rate Rl=bl/cl=6/7 arranged to interlace with binary parity-check matrix for LDPC-CC2 with rate R2=b2/c2=7/8

(Matrix portion : rows 1-10 and columns 1-24)

In this way, the following correspondence between the rows of the two auxiliary seed matrices and the seed matrix to be generated 51 by the seed matrix generator 41, i.e. the seed matrix of the LDPC-CTC is obtained:

| Rows of the first auxiliary seed matrix (table Ibis) | Rows of the seed matrix of the LDPC-CTC |
|---|---|
| Row 1 | Row 1 |
| Row 2 | Row 3 |
| Row 3 | Row 5 |
| Row 4 | Row 7 |
| Row 5 | Row 9 |
| Row 6 | Row 11 |
| ... | ... |

| Rows of the second auxiliary seed matrix (table 2) | Rows of the seed matrix of the LDPC-CTC |
|---|---|
| Row 1 | Row 2 |
| Row 2 | Row 4 |
| Row 3 | Row 6 |
| Row 4 | Row 8 |
| Row 5 | Row 10 |
| Row 6 | Row 12 |
| ... | ... |

Therefore, even if the LDPC-CTC consists of several LDPC-CCs placed in parallel form, a single seed matrix, a single exponent parity-check matrix and a single binary parity-check matrix are obtained, which are used in the encoding 43, 53 and/or decoding 64, 74 processes.

As already happens for the LDPC block codes (LDPC-BC) carried-out with semi-random technique (the most employed), according to an embodiment, in the encoding process 43, 53 the exponent parity-check matrix of the LDPC-CTC is used for encoding 43 because the exponent parity-check matrix of the LDPC-CTC takes advantage of the cyclic permutation matrix features, and in the decoding process 64, 74 the binary parity-check matrix of the LDPC-CTC is used for decoding 64, 74.

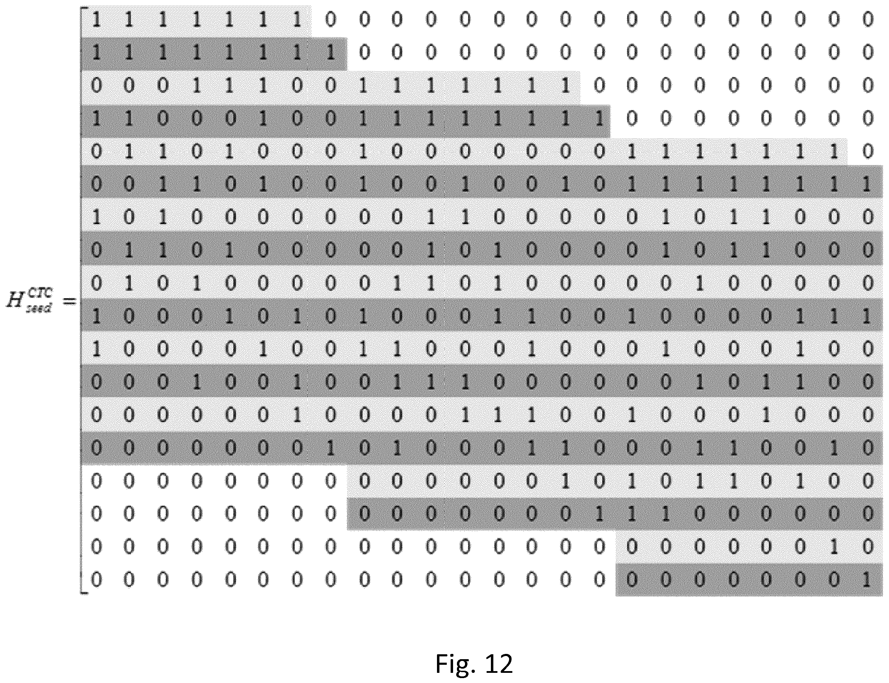

Fig. 12 shows a portion of a generated 51 seed matrix for LDPC-CTC according to an embodiment of the present invention. The seed matrix of Fig. 12 is generated 51 according to the embodiment of Fig. 11.

For the LDPC-CC$_1$ encoder (part of the encoding device 4 of Fig. 11), the equation (7) remains unchanged, but now it is expressed for a code rate $R_1 = {}^6\!/_7$ by the following equation (11):

$$
\begin{cases}
v_{n1}^{cc1} = u_{n1} \quad, \quad v_{n2}^{cc1} = u_{n2} \quad, \quad v_{n3}^{cc1} = u_{n3} \quad, \quad v_{n4}^{cc1} = u_{n4} \quad, \quad v_{n5}^{cc1} = u_{n5} \quad, \quad v_{n6}^{cc1} = u_{n6} \\[2em]
v_{n7}^{cc1} = \sum_{i=0}^{M} h_1^{(i)}(n) \cdot u_{(n-i)1} + \sum_{i=0}^{M} h_2^{(i)}(n) \cdot u_{(n-i)2} + \dots\dots + \sum_{i=0}^{M} h_6^{(i)}(n) \cdot u_{(n-i)6} + \sum_{i=1}^{M} h_7^{(i)}(n) \cdot v_{(n-i)7}^{cc1}
\end{cases}
$$

For the LDPC-CC$_2$ encoder (part of the encoding device 4 of Fig. 11), with code rate $R_2 = 7/8$, the equation (7) becomes the following equation (12):

$$
\begin{cases}
v_{n1}^{cc2} = u_{n1} \quad, \quad v_{n2}^{cc2} = u_{n2} \quad, \quad v_{n3}^{cc2} = u_{n3} \quad, \quad \dots\dots\dots \quad, \quad v_{n6}^{cc2} = u_{n6} \quad, \quad v_{n7}^{cc2} = v_{n7}^{cc1} \quad 5 \\[2em]
v_{n8}^{cc2} = \sum_{i=0}^{M} \gamma_1^{(i)}(n) \cdot u_{(n-i)1} + \sum_{i=0}^{M} \gamma_2^{(i)}(n) \cdot u_{(n-i)2} + \dots\dots + \sum_{i=0}^{M} \gamma_7^{(i)}(n) \cdot v_{(n-i)7}^{cc1} + \sum_{i=1}^{M} \gamma_8^{(i)}(n) \cdot v_{(n-i)8}^{cc2}
\end{cases}
$$

Both equation (11) and equation (12) are based on Alberto Jimenez Felstrom, Kamil Zigangirov: "Time-varying periodic convolutional codes with low density parity-check matrix", IEEE Trans. Information Theory 45 (6): 2181-2191 (1999), which is incorporated herein by reference.

To carry out the binary LDPC-CTC encoder 43, the equations (11) and (12) are rearranged according to an embodiment as in the following equation (13):

$$
\begin{cases}
v_{n1}^{cc2} = v_{n1}^{cc1} = u_{n1} \quad, \quad v_{n2}^{cc2} = v_{n2}^{cc1} = u_{n2} \quad, \quad \dots \quad, \quad v_{n5}^{cc2} = v_{n5}^{cc1} = u_{n5} \quad, \quad v_{n6}^{cc2} = v_{n6}^{cc1} = u_{n6} \\[2em]
v_{n7}^{cc1} = \sum_{i=0}^{M} h_1^{(i)}(n) \cdot u_{(n-i)1} + \sum_{i=0}^{M} h_2^{(i)}(n) \cdot u_{(n-i)2} + \dots\dots + \sum_{i=0}^{M} h_6^{(i)}(n) \cdot u_{(n-i)6} + \sum_{i=1}^{M} h_7^{(i)}(n) \cdot v_{(n-i)7}^{cc1} \\[2em]
v_{n8}^{cc2} = \sum_{i=0}^{M} \gamma_1^{(i)}(n) \cdot u_{(n-i)1} + \sum_{i=0}^{M} \gamma_2^{(i)}(n) \cdot u_{(n-i)2} + \dots\dots + \sum_{i=0}^{M} \gamma_7^{(i)}(n) \cdot v_{(n-i)7}^{cc1} + \sum_{i=1}^{M} \gamma_8^{(i)}(n) \cdot v_{(n-i)8}^{cc2}
\end{cases}
$$

The above equation (13) allows to carry-out the binary LDPC-CTC encoder 43 with code rate

$$
R = R_1 \cdot R_2 = (6/7) \cdot (7/8) = 3/4.
$$

The binary parity-check matrix of the LDPC-CTC is used as the generated 51 seed matrix.

The generated 51 seed matrix for a specific rate R, built as described herein, masked with the full exponent

matrix $E_{exp}$ for the rate R and expanded with the spreading matrix (e.g., cyclic permutation matrix), produces binary parity-check matrix $H_{rxn}$ for the LDPC-CTC which leads to significant performance gains.

With the present invention it is possible to carry-out a parallel layered decoding 64, 74 with good performances (fast convergence of the belief propagation algorithm) and low decoding latency.

The LDPC - CTC does not use an interleaver circuit because such operation is carried-out from the spreading matrixes with different exponent value for each parallel path (two or more).

The skilled person will find the trade-off between the desired performances and the parallel concatenated LDPC-CC number, deciding, e.g., on hardware complexity.

The real code rate of an LDPC-CTC for tail-biting (TB-LDPC-CTC) is tied to the construction rate of the code $R = b / c$, to the parallel LDPC-CC number w, to the code period length $T$, to the code period number $p$ and parity element number $r = c - b$.

The exponent parity-check matrix LDPC-CTC, generated 52 by use of the generated 51 seed matrix and used for encoding 43, 53, has, for example, at least the following characteristics:

- $p \cdot w \cdot c \cdot T + w \cdot c = (p \cdot T + 1) \cdot w \cdot c$ as exponent parity-check matrix column number;

- $(p - 1) \cdot w \cdot b \cdot T$ as information column number for tail-biting;

- $p \cdot w \cdot r \cdot T + w \cdot r = (p \cdot T + 1) \cdot w \cdot r$ as exponent parity-check matrix row number; and

- $H_{exp}((p \cdot T + 1) \cdot w \cdot r, (p \cdot T + 1) \cdot w \cdot c)$ as exponent parity-check matrix size.

The real rate for TB-LPCC-CTC becomes:

$$R_{TB}^{CTC} = \frac{(p-1)\cdot w\cdot b\cdot T}{(p-1)\cdot w\cdot b\cdot T+(p\cdot T+1)\cdot w\cdot r} = \frac{(p-1)\cdot w\cdot b\cdot T}{(p\cdot c-b)\cdot w\cdot T+(c-b)\cdot w} \qquad (14)$$

In the following, three cases are considered and both real rate for TB-LDPC-CTC using equation (14) and the exponent parity-check matrix size are computed:

1.

$$p = 3 \quad \Rightarrow \quad \begin{cases} R_{TB}^{CTC} = \dfrac{(p-1)\cdot w\cdot b\cdot T}{(p\cdot c-b)\cdot w\cdot T+(c-b)\cdot w} = \dfrac{60}{92} = 0.652 \\[4mm] H_{exp}^{CTC}(32,128) \end{cases} \qquad (15)$$

2.

$$p = 10 \quad \Rightarrow \quad \begin{cases} R_{TB}^{CTC} = \dfrac{(p-1)\cdot w\cdot b\cdot T}{(p\cdot c-b)\cdot w\cdot T+(c-b)\cdot w} = \dfrac{270}{372} = 0.726 \\[4mm] H_{exp}^{CTC}(102,408) \end{cases} \qquad (16)$$

3.

$$p = 100 \Rightarrow \begin{cases} R_{TB}^{CTC} = \dfrac{(p-1) \cdot w \cdot b \cdot T}{(p \cdot c - b) \cdot w \cdot T + (c-b) \cdot w} = \dfrac{2970}{3972} = 0.748 \\ \\ H_{\exp}^{CTC}(1002, 4008) \end{cases} \qquad (17)$$

Increasing the code period number that is increasing the code word length, the real rate of the TB-LDPC-CTC tends asymptotically to the construction rate of the LDPC - CTC, in this case:

$$R = b/c = 3/4 = 0.75$$

Looking at the generated 52 exponent parity-check matrix it can be noted that it is periodic both for rows and for columns.

The periodicity of the rows is equal to the product $w \cdot r \cdot T = w \cdot (c - b) \cdot T = 10$ while the periodicity of the columns is equal to the product $w \cdot c \cdot T = 40$.

Then it is not necessary to store the real size for both the exponent parity-check matrix $H_{\exp}$ and the binary parity-check matrix $H_{rxn}$ but only for exponent matrix $w \cdot r \cdot T = 10$ rows and for binary matrix $w \cdot r \cdot T \cdot Z_f = 10 \cdot 48 = 480$ rows for all three previous cases.

To generate the exponent matrix, with the known art rules, it operates for columns because it is possible to use 40 increment steps (unlike the same operation for rows which would only 10 increment steps). The use of several increment steps in the exponent parity matrix construction allows to achieve overlap factor less than or equal to "1" ($\leq$ 1) ; for overlap factor it means the scalar product between any two columns of the binary parity-check matrix $H_{\exp}$. The previous condition (overlap factor ($\leq$ 1) makes robust the LDPC-CC that is without 4-length minimum cycles which determine a degradation of the iterative decoding algorithm that is a degradation of the codec performances (for skilled person these statements are clear and known).

In the encoding step or process 53 the exponent parity-check matrix $H_{\exp}$ is used, which takes advantage from the following properties

- the product between two cyclic permutation matrixes of the identity matrix with exponents respectively $\alpha$ and $\beta$ produces always a cyclic permutation matrix of the identity matrix with exponent ($\alpha + \beta$); and

- the product between a cyclic permutation matrix of the identity matrix with exponent $\alpha$ and a vector of size $Z_f$ produces the same vector of size $Z_f$ but with a cyclic shift of its elements equal to $\alpha$.

In the decoding step or process 64, 74 the binary parity-check matrix is used because the iterative algorithm updates the single reliability value, which corresponds to the single bit.

Let the block structured information sequence be $U_{[0,n]}$ and block structured encoded sequence $V_{[0,n]}$, then:

$$U_{[0,n]} = [U_{01}, U_{02}, ..., U_{06}, U_{11}, U_{12}, ..., U_{16}, ......., U_{n1}, U_{n2}, ..., U_{n6}] \qquad (18)$$

$$V_{[0,n]} = [V_{01}, V_{02}, ..., V_{06}, V_{07}, V_{08}, V_{11}, V_{12}, ..., V_{16}, V_{17}, V_{18}, ..., V_{n1}, V_{n2}, ..., V_{n6}, V_{n7}, V_{n8}] \qquad (19)$$

The single elements $\{U_{ij}, V_{ij}\}$ are vectors of size equal to spreading factor $Z_f = 48$. The received information 105 will be correct if the following equation will be satisfied:

$$\hat{V}_{[0,n]} \cdot H_{\exp}^T = 0 \qquad (20)$$

The systematic block structured LDPC-CTC encoder 43, derived from the binary LDPC-CTC encoder equation (13), will be carried-out with the following equations:

$$\begin{cases} V_{n1} = U_{n1} \quad , \quad V_{n2} = U_{n2} \quad , \quad ... \quad , \quad V_{n5} = U_{n5} \quad , \quad V_{n6} = U_{n6} \\ \\ V_{n7} = \sum_{i=0}^{M} H_1^{(i)}(n) \cdot U_{(n-i)1} + \sum_{i=0}^{M} H_2^{(i)}(n) \cdot U_{(n-i)2} + ...... + \sum_{i=0}^{M} H_6^{(i)}(n) \cdot U_{(n-i)6} + \sum_{i=1}^{M} H_7^{(i)}(n) \cdot V_{(n-i)7} \\ \\ V_{n8} = \sum_{i=0}^{M} \Gamma_1^{(i)}(n) \cdot U_{(n-i)1} + \sum_{i=0}^{M} \Gamma_2^{(i)}(n) \cdot U_{(n-i)2} + ...... + \sum_{i=0}^{M} \Gamma_7^{(i)}(n) \cdot V_{n7} + \sum_{i=1}^{M} \Gamma_8^{(i)}(n) \cdot V_{(n-i)8} \end{cases} \tag{21}$$

Exponents $H_1^{(i)}(n)$, $H_2^{(i)}(n)$,......, $H_6^{(i)}(n)$, $H_7^{(i)}(n)$ and $\Gamma_1^{(i)}(n)$, $\Gamma_2^{(i)}(n)$,......, $\Gamma_7^{(i)}(n)$, $\Gamma_8^{(i)}(n)$ of the LDPC-CTC parity-check matrix are cyclic permutation matrix of size $Z_f = 48$; the coefficients $H_1^{(i)}(n)$, $H_2^{(i)}(n)$,......, $H_6^{(i)}(n)$ and $\Gamma_1^{(i)}(n)$, $\Gamma_2^{(i)}(n)$,......, $\Gamma_7^{(i)}(n)$ are tied to the information sequence while the coefficients $H_7^{(i)}(n)$ and $\Gamma_8^{(ii)}(n)$ are tied to the parity sequence, respectively, of LDPC-CC$_1$ and LDPC-CC2; each time slot $n$ = 0, 1, 2, 3,.... corresponds to a block of $w \cdot c \cdot Z_f = 384$ bits ($w \cdot b \cdot Z_f = 288$ information bits and $w \cdot r \cdot Z_f = 96$ parity bits).

The coefficients $H_j^{(i)}(n)$, $\Gamma_j^{(i)}(n)$ are always between 0 and $(Z_f - 1) = 47$ but the coefficients $H_7^{(0)}(n)$, $\Gamma_8^{(0)}(n)$, which correspond to the parity columns of the exponent matrix, are always equal to "0" to minimize the hardware complexity of the LDPC-CTC encoding process 43, 53; then the coefficients $H_7^{(0)}(n)$, $\Gamma_8^{(0)}(n)$ correspond always to the identity matrix.

In other words, to reduce the arithmetic operation number in the LDPC-CTC encoding step or process 53, the exponent parity-check matrix is generated by putting to "0" (cyclic permutation matrix equal to the identity matrix) the last exponent (rightmost element) of each row ( $H_7^{(0)}(n)$, $\Gamma_8^{(0)}(n)$ for all time slots $n$ = 0,1,2,3,....) corresponding to the encoded parity sequence.

| 33 | 6 | 15 | 36 | 30 | 24 | 0 | −1 | −1 | −1 | −1 | −1 | −1 | −1 | −1 | −1 | −1 | −1 | −1 | −1 | −1 |
|---|---|---|---|---|---|---|---|---|---|---|---|---|---|---|---|---|---|---|---|---|
| 36 | 22 | 40 | 42 | 17 | 5 | 13 | 0 | −1 | −1 | −1 | −1 | −1 | −1 | −1 | −1 | −1 | −1 | −1 | −1 | −1 |
| −1 | −1 | −1 | 0 | 4 | 39 | −1 | −1 | 35 | 20 | 1 | 25 | 39 | 9 | 0 | −1 | −1 | −1 | −1 | −1 | −1 |
| 42 | 1 | −1 | −1 | −1 | 20 | −1 | −1 | 40 | 2 | 12 | 7 | 0 | 28 | 21 | 0 | −1 | −1 | −1 | −1 | −1 |
| −1 | 17 | 9 | −1 | 31 | −1 | −1 | −1 | 45 | −1 | −1 | −1 | −1 | −1 | −1 | −1 | 31 | 37 | 2 | 13 | 21 |
| −1 | −1 | 34 | 13 | −1 | 35 | −1 | −1 | 2 | −1 | −1 | 24 | −1 | −1 | 10 | −1 | 32 | 44 | 14 | 36 | 4 |

table 3) Exponent parity-check matrix LDPC-CTC, rate R=3/4 - spreading Zf=48 (Exponent matrix portion: rows 1-6 and columns 1-21)

$$40 \;\; -1 \;\; 41 \;\; -1 \;\; 16 \;\; 31 \;\; -1 \;\; 1 \;\; -1 \;\; -1 \;\; -1 \;\; -1 \;\; -1 \;\; 1 \;\; -1 \;\; 37 \;\; -1 \;\; -1 \;\; 4 \;\; -1 \;\; -1$$

$$-1 \;\; 20 \;\; 42 \;\; 8 \;\; -1 \;\; -1 \;\; -1 \;\; -1 \;\; -1 \;\; -1 \;\; 24 \;\; 5 \;\; 11 \;\; -1 \;\; -1 \;\; -1 \;\; -1 \;\; .-1 \;\; 23 \;\; -1 \;\; -1$$

$$-1 \;\; -1 \;\; -1 \;\; -1 \;\; -1 \;\; -1 \;\; -1 \;\; -1 \;\; 28 \;\; -1 \;\; -1 \;\; 33 \;\; -1 \;\; -1 \;\; -1 \;\; 18 \;\; -1 \;\; -1 \;\; -1 \;\; -1 \;\; 13$$

$$-1 \;\; -1 \;\; -1 \;\; -1 \;\; -1 \;\; -1 \;\; -1 \;\; -1 \;\; -1 \;\; 47 \;\; -1 \;\; -1 \;\; -1 \;\; 3 \;\; -1 \;\; 35 \;\; -1 \;\; -1 \;\; 18 \;\; 24 \;\; -1$$

$$-1 \;\; -1 \;\; -1 \;\; -1 \;\; -1 \;\; -1 \;\; -1 \;\; -1 \;\; -1 \;\; -1 \;\; -1 \;\; -1 \;\; -1 \;\; -1 \;\; -1 \;\; -1 \;\; 4 \;\; -1 \;\; -1 \;\; 38 \;\; 24$$

$$-1 \;\; -1 \;\; -1 \;\; -1 \;\; -1 \;\; -1 \;\; -1 \;\; -1 \;\; -1 \;\; -1 \;\; -1 \;\; -1 \;\; -1 \;\; -1 \;\; -1 \;\; -1 \;\; -1 \;\; 32 \;\; -1 \;\; -1 \;\; 3$$

table 3) Exponent parity-check matrix LDPC-CTC, rate R=3/4 - spreading Zf=48 (Exponent matrix portion: rows 15-20 and columns 15-35)

The exponent parity check matrix for the LDPC-CTC (table 3) is obtained by masking a full exponent parity check matrix with the seed matrix for the LDPC-CTC shown in figure 12.

To carry-out the LDPC-CTC encoder 4 using the exponent parity-check matrix table 3, the LDPC-CTC encoder 4 must operate in this way:

- Time slot $n = 0 \Rightarrow$ info sequence $U_{01}, U_{02}, ..., U_{06}$, parity sequence $V_{07}, V_{08}$:

$$I_{Z_f}^{(0)} \cdot V_{07} = I_{Z_f}^{(33)} \cdot U_{01} + I_{Z_f}^{(6)} \cdot U_{02} + I_{Z_f}^{(15)} \cdot U_{03} + I_{Z_f}^{(36)} \cdot U_{04} + I_{Z_f}^{(30)} \cdot U_{05} + I_{Z_f}^{(24)} \cdot U_{06}$$

$$\Rightarrow \text{ first row of } H_{\text{exp}}$$

$$I_{Z_f}^{(0)} \cdot V_{08} = I_{Z_f}^{(36)} \cdot U_{01} + I_{Z_f}^{(22)} \cdot U_{02} + I_{Z_f}^{(40)} \cdot U_{03} + I_{Z_f}^{(42)} \cdot U_{04} + I_{Z_f}^{(17)} \cdot U_{05} + I_{Z_f}^{(54)} \cdot U_{06} + I_{Z_f}^{(13)} \cdot V_{07}$$

$$5$$

$$\Rightarrow \text{ second row of } H_{\text{exp}}$$

- Time slot $n = 1 \Rightarrow$ info sequence $U_{11}, U_{12}, ..., U_{16}$, parity sequence $V_{17}, V_{18}$:

$$I_{Z_f}^{(0)} \cdot V_{17} = I_{Z_f}^{(0)} \cdot U_{04} + I_{Z_f}^{(4)} \cdot U_{05} + I_{Z_f}^{(39)} \cdot U_{06} + I_{Z_f}^{(35)} \cdot U_{11} + I_{Z_f}^{(20)} \cdot U_{12} +$$

$$+ I_{Z_f}^{(1)} \cdot U_{13} + I_{Z_f}^{(25)} \cdot U_{14} + I_{Z_f}^{(39)} \cdot U_{15} + I_{Z_f}^{(9)} \cdot U_{16} \Rightarrow \text{ third row of } H_{\text{exp}}$$

$$I_{Z_f}^{(0)} \cdot V_{18} = I_{Z_f}^{(42)} \cdot U_{01} + I_{Z_f}^{(1)} \cdot U_{02} + I_{Z_f}^{(20)} \cdot U_{06} + I_{Z_f}^{(40)} \cdot U_{11} + I_{Z_f}^{(2)} \cdot U_{12} +$$

$$+ I_{Z_f}^{(12)} \cdot U_{13} + I_{Z_f}^{(7)} \cdot U_{14} + I_{Z_f}^{(0)} \cdot U_{15} + I_{Z_f}^{(28)} \cdot U_{16} + I_{Z_f}^{(21)} \cdot V_{17} \Rightarrow \text{ fourth row of } H_{\text{exp}}$$

- Time slot $n = 2 \Rightarrow$ info sequence $U_{21}, U_{22}, ..., U_{26}$, parity sequence $V_{27}, V_{28}$:

$$I_{Z_f}^{(0)} \cdot V_{27} = I_{Z_f}^{(17)} \cdot U_{02} + I_{Z_f}^{(9)} \cdot U_{03} + I_{Z_f}^{(31)} \cdot U_{05} + I_{Z_f}^{(45)} \cdot U_{11} + I_{Z_f}^{(31)} \cdot U_{21} +$$

$$+ I_{Z_f}^{(37)} \cdot U_{22} + I_{Z_f}^{(2)} \cdot U_{23} + I_{Z_f}^{(13)} \cdot U_{24} + I_{Z_f}^{(21)} \cdot U_{25} + I_{Z_f}^{(5)} \cdot U_{26} \Rightarrow \text{ fifth row of } H_{\text{exp}}$$

$$I_{Z_f}^{(0)} \cdot V_{28} = I_{Z_f}^{(34)} \cdot U_{03} + I_{Z_f}^{(13)} \cdot U_{04} + I_{Z_f}^{(35)} \cdot U_{06} + I_{Z_f}^{(2)} \cdot U_{11} + I_{Z_f}^{(24)} \cdot U_{24} +$$

$$+ I_{Z_f}^{(10)} \cdot V_{17} + I_{Z_f}^{(32)} \cdot U_{21} + I_{Z_f}^{(44)} \cdot U_{22} + I_{Z_f}^{(14)} \cdot U_{23} + I_{Z_f}^{(36)} \cdot U_{24} +$$

$$+ I_{Z_f}^{(4)} \cdot U_{25} + I_{Z_f}^{(20)} \cdot U_{26} + I_{Z_f}^{(20)} \cdot V_{27} \quad \Rightarrow \quad \text{sixth row of } H_{\text{exp}}$$

- ... ... ... ...
- Time slot $n = 7 \Rightarrow$ info sequence $U_{71}, U_{72}, ..., U_{76}$, parity sequence $V_{77}, V_{78}$:

$$I_{Z_f}^{(0)} \cdot V_{77} = I_{Z_f}^{(40)} \cdot V_{17} + I_{Z_f}^{(41)} \cdot U_{21} + I_{Z_f}^{(16)} \cdot U_{23} + I_{Z_f}^{(31)} \cdot U_{24} + I_{Z_f}^{(1)} \cdot U_{26} +$$

$$+ I_{Z_f}^{(1)} \cdot U_{34} + I_{Z_f}^{(37)} \cdot U_{36} + I_{Z_f}^{(33)} \cdot U_{41} + I_{Z_f}^{(4)} \cdot U_{42} + I_{Z_f}^{(17)} \cdot U_{52} + \qquad (22)$$

$$+ I_{Z_f}^{(9)} \cdot U_{53} + I_{Z_f}^{(31)} \cdot U_{55} + I_{Z_f}^{(45)} \cdot U_{61} + I_{Z_f}^{(31)} \cdot U_{71} + I_{Z_f}^{(37)} \cdot U_{72} +$$

$$+ I_{Z_f}^{(2)} \cdot U_{73} + I_{Z_f}^{(13)} \cdot U_{74} + I_{Z_f}^{(21)} \cdot U_{75} + I_{Z_f}^{(5)} \cdot U_{76} \quad \Rightarrow \quad \text{fifteenth row of } H_{\text{exp}}$$

$$I_{Z_f}^{(0)} \cdot V_{78} = I_{Z_f}^{(20)} \cdot V_{18} + I_{Z_f}^{(42)} \cdot U_{21} + I_{Z_f}^{(8)} \cdot U_{22} + I_{Z_f}^{(24)} \cdot U_{31} + I_{Z_f}^{(5)} \cdot U_{32} +$$

$$+ I_{Z_f}^{(11)} \cdot U_{33} + I_{Z_f}^{(23)} \cdot U_{42} + I_{Z_f}^{(44)} \cdot V_{47} + I_{Z_f}^{(34)} \cdot U_{53} + I_{Z_f}^{(13)} \cdot U_{54} + \qquad (23)$$

$$+ I_{Z_f}^{(35)} \cdot U_{56} + I_{Z_f}^{(2)} \cdot U_{61} + I_{Z_f}^{(24)} \cdot U_{64} + I_{Z_f}^{(10)} \cdot V_{67} + I_{Z_f}^{(32)} \cdot U_{71} +$$

$$+ I_{Z_f}^{(44)} \cdot U_{72} + I_{Z_f}^{(14)} \cdot U_{73} + I_{Z_f}^{(36)} \cdot U_{74} + I_{Z_f}^{(4)} \cdot U_{75} + I_{Z_f}^{(20)} \cdot U_{76} + I_{Z_f}^{(20)} \cdot V_{77}$$

$$\Rightarrow \quad \text{sixteenth row of } H_{\text{exp}}$$

The exponent parity-check matrix $H_{\text{exp}}$ will be composed, for this implementation example, from the row 13 up to row 22 being $w \cdot r \cdot T = 10$.

As already said before, by having placed to "0" the last exponent (rightmost element) of each row ( $H_7^{(0)}(n)$ , $\Gamma_8^{(0)}(n)$ for all time slots $n = 0, 1, 2, 3, ....$) which correspond to the encoded parity sequence, the arithmetic operation number in the encoding process is minimized.

In fact, the below products become:

$$I_{Z_f}^{(0)} \cdot V_{07} = V_{07}, \ I_{Z_f}^{(0)} \cdot V_{08} = V_{08}, \ ..., \ I_{Z_f}^{(0)} \cdot V_{77} = V_{77}, \ I_{Z_f}^{(0)} \cdot V_{78} = V_{78} \qquad (24)$$

without any arithmetic operation on the vectors belonging to the current time slot

$$V_{07}, \ V_{08}, \ V_{17}, \ V_{18}, \ V_{27}, \ V_{28}, \ ..., \ V_{77}, \ V_{78}, \ ...$$

For example to compute the encoded parity sequences $V_{77}$, $V_{78}$, equations (22) and (23), corresponding to the time slot $n = 7$ , are carried out:

- "*40*" cyclic shifts for info/parity sequence vectors,
- "*38*" addition operations for info/parity sequence vectors.

Thus, the present invention relates to a device - a seed matrix generator 41 - and a corresponding method, both configured to generate a seed matrix that is arranged to be used for encoding 53 an information 101 and/or for decoding 64, 74 an encoded information 105, wherein the seed matrix generator 41 is arranged to generate the seed matrix based on at least one low-density parity-check convolutional code, LDPC-CC. The seed matrix is, according to an embodiment, a seed matrix of a LDPC convolutional turbo code, LDPC-CTC. Further, the present invention relates to an encoding device 4 and a corresponding method 5, both configured to encode information 101 by use of the seed matrix, to a decoding device 6 and a corresponding method 7, both configured to decode information by use of the seed matrix.

In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage.

## Claims

1. A seed matrix generator (41) to be used for parallel layered decoding an encoded information, wherein the seed matrix generator is arranged to generate (51) a seed matrix, the seed matrix being a binary parity check matrix of two parallel low-density parity-check convolutional codes, LDPC-CC, wherein the seed matrix is a seed matrix of a LDPC convolutional turbo code, LDPC-CTC, wherein the seed matrix generator is arranged to generate (51) the seed matrix by:

   - generating (511) w auxiliary seed matrices for w parallel LDPC-CCs, wherein each one of the w auxiliary seed matrices is generated for one of the w parallel LDPC-CCs, wherein w is 2; and **characterized in that** the seed matrix generator is further arranged to generate (51) the seed matrix by:
   - interlacing (512) the generated w auxiliary seed matrices of the w parallel LDPC-CCs to generate the seed matrix of the LDPC-CTC placing a first auxiliary seed matrix of the w auxiliary seed matrices on the odd rows of the seed matrix of the LDPC-CTC and by placing a second auxiliary seed matrix of the w auxiliary seed matrices on the even rows of the seed matrix of the LDPC-CTC, wherein each of the auxiliary seed matrices has a different code rate $R_\beta$, wherein $\beta$ is a positive integer and $1 \leq \beta \leq w$, and wherein the code rate $R_\beta$ is determined by the following equation:

$$R_\beta = \frac{(w \cdot b - 1) + \beta}{w \cdot (c - 1) + \beta},$$

   wherein the information is a sequence of information bits, b is a number of the information bits of the sequence, and wherein the encoded information is a sequence of encoded bits and c is a number of the encoded information bits.

2. A decoding device (6) arranged to execute a decoding of an encoded information being a sequence of encoded information bits, said decoding device comprising a seed matrix generator (41) configured to generate a seed matrix that is arranged to be used for the decoding of the information and being a seed matrix generator according to claim 1.

## Patentansprüche

1. "Seed"-Matrix-Generator (41) zur Verwendung zur parallel geschichteten Decodierung einer codierten Information, wobei der "Seed"-Matrix-Generator ausgelegt ist zum Erzeugen (41) einer "Seed"-Matrix, wobei die "Seed"-Matrix eine Binär-Paritätsprüfmatrix zweier paralleler "Low-Density Parity-Check"-Faltungscodes bzw. LDPC-CC ist, wobei die "Seed"-Matrix eine "Seed"-Matrix eines LDPC-Faltungsturbocodes bzw. LDPC-CTC ist, wobei der "Seed"-Matrix-Generator ausgelegt ist zum Erzeugen (51) der "Seed"-Matrix durch

   - Erzeugen (511) von w Hilfs-"Seed"-Matrizen für w parallele LDPC-CC, wobei jede der w Hilfs-"Seed"-Matrizen für einen der w parallelen LDPC-CC erzeugt wird, wobei w 2 ist; und **dadurch gekennzeichnet, dass** der "Seed"-Matrix-Generator ferner ausgelegt ist zum Erzeugen (51) der "Seed"-Matrix durch
   - Verschachteln (512) der erzeugten w Hilfs-"Seed"-Matrizen der w parallelen LDPC-CC, um die "Seed"-Matrix des LDPC-CTC zu erzeugen, wobei eine erste Hilfs-"Seed"-Matrix der w Hilfs-"Seed"-Matrizen auf den ungeraden Zeilen der "Seed"-Matrix des LDPC-CTC platziert wird, und durch Platzieren einer zweiten Hilfs-"Seed"-Matrix der w Hilfs-"Seed"-Matrizen auf den geraden Zeilen der "Seed"-Matrix des LDPC-CTC, wobei jede der Hilfs-"Seed"-Matrizen eine andere Coderate $R_\beta$ aufweist, wobei $\beta$ eine positive ganze Zahl und $1 \leq \beta \leq w$ ist und wobei die Coderate $R_\beta$ durch die folgende Gleichung bestimmt wird:

$$R_\beta = \frac{(w \cdot b - 1) + \beta}{w \cdot (c - 1) + \beta},$$

wobei die Information eine Sequenz von Informationsbit ist, b eine Anzahl der Informationsbit der Sequenz ist und wobei die codierte Information eine Sequenz codierter Bit ist und c eine Anzahl der codierten Informationsbit ist.

2. Decodierungsvorrichtung (6), ausgelegt zum Ausführen einer Decodierung einer codierten Information, die eine Sequenz codierter Informationsbit ist, wobei die Decodierungsvorrichtung einen "Seed"-Matrix-Generator (41) umfasst, der dafür ausgelegt ist, eine "Seed"-Matrix zu erzeugen, die für Verwendung zur Decodierung der Information ausgelegt ist, und der ein "Seed"-Matrix-Generator nach Anspruch 1 ist.

## Revendications

1. Générateur de matrice de graines (41) devant être utilisé pour le décodage hiérarchique en parallèle d'une information codée, le générateur de matrice de graines étant conçu pour générer (51) une matrice de graines, la matrice de graines étant une matrice de contrôle de parité binaire de deux codes convolutifs de contrôle de parité à faible densité, LDPC-CC, parallèles, dans lequel la matrice de graines est une matrice de graines d'un turbo-code convolutif LDPC, LDPC-CTC, dans lequel le générateur de matrice de graines est conçu pour générer (51) la matrice de graines par :

   - la génération (511) de w matrices de graines auxiliaires pour w LDPC-CC parallèles, chacune des w matrices de graines auxiliaires étant générée pour l'un des w LDPC-CC parallèles, w valant 2 ; et **caractérisé en ce que** le générateur de matrice de graines est en outre conçu pour générer (51) la matrice de graines par :
   - l'entrelacement (512) des w matrices de graines auxiliaires générées des w LDPC-CC parallèles pour générer la matrice de graines du LDPC-CTC en plaçant une première matrice de graines auxiliaire des w matrices de graines auxiliaires sur les rangées impaires de la matrice de graines du LDPC-CTC et en plaçant une seconde matrice de graines auxiliaire des w matrices de graines auxiliaires sur les rangées paires de la matrice de graines du LDPC-CTC, chacune des matrices de graines auxiliaires ayant un taux de codage $R_\beta$ différent, $\beta$ étant un nombre entier positif et $1 \leq \beta \leq w$, et le taux de codage $R_\beta$ étant déterminé par l'équation suivante :

$$R_\beta = \frac{(w \cdot b - 1) + \beta}{w \cdot (c - 1) + \beta},$$

dans laquelle l'information est une séquence de bits d'information, b est un nombre des bits d'information de la séquence, et dans laquelle l'information codée est une séquence de bits codés et c est un nombre des bits d'information codée.

2. Dispositif de décodage (6) conçu pour exécuter un décodage d'une information codée étant une séquence de bits d'information codée, ledit dispositif de décodage comprenant un générateur de matrice de graines (41) configuré pour générer une matrice de graines qui est conçue pour être utilisée pour le décodage de l'information et étant un générateur de matrice de graines selon la revendication 1.

Fig. 1

EP 3 529 900 B1

$$H^T = \begin{bmatrix} H_0^{(0)} & H_1^{(1)} & H_2^{(2)} & H_3^{(3)} & . & H_M^{(M)} & 0 & 0 & 0 & 0 & . & 0 \\ 0 & H_1^{(0)} & H_2^{(1)} & H_3^{(2)} & . & H_M^{(M-1)} & H_{M+1}^{(M)} & 0 & 0 & 0 & . & 0 \\ 0 & 0 & H_2^{(0)} & H_3^{(1)} & . & H_M^{(M-2)} & H_{M+1}^{(M-1)} & H_{M+2}^{(M)} & 0 & 0 & . & 0 \\ 0 & 0 & 0 & H_3^{(0)} & . & H_M^{(M-3)} & H_{M+1}^{(M-2)} & H_{M+2}^{(M-1)} & H_{M+3}^{(M)} & 0 & . & 0 \\ . & . & . & . & . & . & . & . & . & . & . & . \\ 0 & 0 & 0 & 0 & . & 0 & H_{[(M-1)\cdot p-1]}^{(0)} & H_{[(M-1)\cdot p]}^{(1)} & H_{[(M-1)\cdot p+1]}^{(2)} & . & . & H_{[M+2\cdot T-1]}^{(M)} \end{bmatrix} \qquad (1)$$

Fig. 2

EP 3 529 900 B1

$$H^T = \begin{bmatrix}
h_1^{(0)}(0) & h_1^{(1)}(1) & h_1^{(2)}(2) & . & h_1^{(7)}(7) & 0 & 0 & . & 0 & 0 & . & 0 \\
h_2^{(0)}(0) & h_2^{(1)}(1) & h_2^{(2)}(2) & . & h_2^{(7)}(7) & 0 & 0 & . & 0 & 0 & . & 0 \\
h_3^{(0)}(0) & h_3^{(1)}(1) & h_3^{(2)}(2) & . & h_3^{(7)}(7) & 0 & 0 & . & 0 & 0 & . & 0 \\
0 & h_1^{(0)}(1) & h_1^{(1)}(2) & . & h_1^{(6)}(7) & h_1^{(7)}(8) & 0 & . & 0 & 0 & . & 0 \\
0 & h_2^{(0)}(1) & h_2^{(1)}(2) & . & h_2^{(6)}(7) & h_2^{(7)}(8) & 0 & . & 0 & 0 & . & 0 \\
0 & h_3^{(0)}(1) & h_3^{(1)}(2) & . & h_3^{(6)}(7) & h_3^{(7)}(8) & 0 & . & 0 & 0 & . & 0 \\
0 & 0 & h_1^{(0)}(2) & . & h_1^{(5)}(7) & h_1^{(6)}(8) & h_1^{(7)}(9) & . & 0 & 0 & . & 0 \\
0 & 0 & h_2^{(0)}(2) & . & h_2^{(5)}(7) & h_2^{(6)}(8) & h_2^{(7)}(9) & . & 0 & 0 & . & 0 \\
0 & 0 & h_3^{(0)}(2) & . & h_3^{(5)}(7) & h_3^{(6)}(8) & h_3^{(7)}(9) & . & 0 & 0 & . & 0 \\
. & . & . & . & . & . & . & . & . & . & . & . \\
. & . & . & . & . & . & . & . & . & . & . & . \\
. & . & . & . & . & . & . & . & . & . & . & . \\
0 & 0 & 0 & . & 0 & 0 & 0 & . & h_1^{(0)}(11) & h_1^{(1)}(12) & . & h_1^{(7)}(18) \\
0 & 0 & 0 & . & 0 & 0 & 0 & . & h_2^{(0)}(11) & h_2^{(1)}(12) & . & h_2^{(7)}(18) \\
0 & 0 & 0 & . & 0 & 0 & 0 & . & h_3^{(0)}(11) & h_3^{(1)}(12) & . & h_3^{(7)}(18)
\end{bmatrix} \tag{2}$$

Fig. 3

Fig. 4b

Fig. 4a

EP 3 529 900 B1

5

51

Generate a seed matrix

Fig. 5a

EP 3 529 900 B1

5

| 51 | Generate a seed matrix |
| --- | --- |
| 52 | Generate an exponent parity check matrix by use of the seed matrix |
| 53 | Encode information by use of the generated exponent parity check matrix |

Fig. 5b

Fig. 6b

Fig. 6a

7

51

Generate a seed matrix

Fig. 7a

EP 3 529 900 B1

**51** — Generate a seed matrix

**52** — Generate an exponent parity check matrix by use of the seed matrix

**73** — Generate a binary parity-check matrix by use of the generated exponent parity check matrix

**74** — Decode encoded information by use of the generated binary parity-check matrix

7

Fig. 7b

EP 3 529 900 B1

51

511 ┌─────────────────────────────────────────────┐
     │                                             │
     │   Generate *w* auxiliary seed matrices for *w*  │
     │            parallel LDPC-CCs                │
     │                                             │
     └─────────────────────────────────────────────┘

512 ┌─────────────────────────────────────────────┐
     │                                             │
     │   Interlace the generated *w* auxiliary seed  │
     │   matrices of the *w* parallel LDPC-CCs       │
     │                                             │
     └─────────────────────────────────────────────┘

Fig. 8

511

| 5111 | Generate each LDPC-CC of the $w$ LDPC-CCs with a corresponding code rate $R_\beta$ |
| 5112 | Output parity sequence of j-th auxiliary seed matrix of j-th LDPC-CC as information sequence in (j+1)-th auxiliary seed matrix of (j+1)-th LDPC-CC |

Fig. 9

Fig. 10

Fig. 11

EP 3 529 900 B1

$$H_{snd}^{crc} =$$

Fig. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20160173132 A1

### Non-patent literature cited in the description

- **ALBERTO JIMENEZ FELSTROM ; KAMIL ZIGAN-GIROV.** Time-varying periodic convolutional codes with low density parity-check matrix. *IEEE Trans. Information Theory,* 1999, vol. 45 (6), 2181-2191
- **T. KISHIGAMI ; Y. MURAKAMI ; I. YOSHII.** *LDPC Convolutional Codes for IEEE 802.16m FEC Scheme*
- **ZHENGANG CHEN et al.** Jointly Designed Architecture-Aware LDPC Convolutional Codes and High-Throughput Parallel Encoders/Decoders. *IEEE TRANSACTIONS ON CIRCUITS AND SYSTEMS I: REGULAR PAPERS, IEEE, US,* vol. 57 (4
- **CHUN-HAO LIAO et al.** An IP generator for quasi-cyclic LDPC convolutional code decoders. *CIRCUITS AND SYSTEMS, 2008. APCCAS 2008. IEEE ASIA PACIFIC CONFERENCE ON, IEEE, PISCATAWAY, NJ, USA*